(19) **Europäisches Patentamt / European Patent Office / Office européen des brevets**

(11) **EP 4 776 448 A1**

(12) # EUROPEAN PATENT APPLICATION
published in accordance with Art. 153(4) EPC

(43) Date of publication:
**15.07.2026 Bulletin 2026/29**

(21) Application number: **24862764.8**

(22) Date of filing: **02.09.2024**

(51) International Patent Classification (IPC):
**H01S 5/18** (2021.01)        **H01S 5/11** (2021.01)

(52) Cooperative Patent Classification (CPC):
**H01S 5/11; H01S 5/18**

(86) International application number:
**PCT/JP2024/031509**

(87) International publication number:
**WO 2025/053112 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.09.2023   JP 2023143264**

(71) Applicant: **Kyoto University**
**Kyoto-shi, Kyoto 606-8501 (JP)**

(72) Inventors:
• **NODA, Susumu**
  **Kyoto-shi, Kyoto 606-8501 (JP)**
• **SAKATA, Ryoichi**
  **Kyoto-shi, Kyoto 606-8501 (JP)**
• **INOUE, Takuya**
  **Kyoto-shi, Kyoto 606-8501 (JP)**
• **ISHIZAKI, Kenji**
  **Kyoto-shi, Kyoto 606-8501 (JP)**
• **MORITA, Ryohei**
  **Kyoto-shi, Kyoto 606-8501 (JP)**
• **DE ZOYSA, Menaka**
  **Kyoto-shi, Kyoto 606-8501 (JP)**

(74) Representative: **Hoeger, Stellrecht & Partner**
**Patentanwälte mbB**
**Uhlandstrasse 14c**
**70182 Stuttgart (DE)**

(54) **TWO-DIMENSIONAL PHOTONIC CRYSTAL LASER**

(57)    A two-dimensional photonic crystal laser (10) includes: an active layer (11); a two-dimensional photonic crystal layer (12) including a plate-shaped base body (121) as well as modified refractive index portions (122) arranged in the base body (121) and having a refractive index different from the base body (121), where the modified refractive index portions are arranged with respective predetermined amounts of displacement from lattice points (124) of a two-dimensional lattice (123) arrayed in two predetermined directions with a period corresponding to the predetermined wavelength, or/and, are arranged at the lattice points and have respective predetermined areas, where the amounts of displacement or/and the areas are modulated with a predetermined modulation period; and a pair of electrodes (17, 18). The active layer (11) includes: a saturable absorber section (112) which is a linear section forming a portion of a predetermined range and having no portion parallel to any one of the two predetermined directions; a gain section (111) occupying a portion other than the saturable absorber section within the predetermined range; and a non-gain section (113) formed around the predetermined range. The saturable absorber section (112) has a lower level of conductivity and a shorter carrier lifetime than the gain region (111).

Fig. 6

**Description**

TECHNICAL FIELD

The present invention relates to a two-dimensional photonic crystal laser.

BACKGROUND ART

A laser light source which generates pulsed laser light with a small pulse width (e.g., less than one nanosecond) has conventionally been demanded in such areas as the sensing or material processing using laser light. Such a pulsed laser light source has the advantage that highly accurate detection of a target or powerful processing of a material can be realized instantaneously by irradiation with extremely strong laser light while damage to the target or material can be suppressed since the period of time for the laser irradiation can be considerably short.

Non Patent Literature 1 discloses a two-dimensional photonic crystal laser capable of emitting pulsed laser light having a pulse width of less than one nanosecond.

A two-dimensional photonic crystal laser normally has: an active layer; a two-dimensional photonic crystal layer including a plate-shaped base body arranged parallel to the active layer as well as areas having a refractive index different from that of the base body (these areas are hereinafter called the "modified retractive index portions"; typically, they consist of holes) and arranged in a two-dimensional form with a predetermined period length in the base body; and a pair of electrodes provided so that the two aforementioned layers are sandwiched between these electrodes in the perpendicular direction to those layers. In such a normal type of two-dimensional photonic crystal laser, when an electric current is passed between the pair of electrodes, light is generated within the active layer, of which a component of light having a wavelength corresponding to the period length of the arrangement of the modified refractive index portions is amplified within the two-dimensional photonic crystal layer and emitted as laser light in a direction perpendicular to the same two-dimensional photonic crystal layer.

By comparison, in a two-dimensional photonic crystal laser disclosed in Non Patent Literature 1, a saturable absorber section having a lower level of conductivity and a shorter lifetime of carriers (pairs of electrons and positive holes) than the section of the active layer in which light is generated by being injected with an electric current (this section is called the "gain section") is formed in a portion of the gain section by a technique which will be described later. The saturable absorber section has the characteristic that, upon receiving an input of light, it initially absorbs light and converts it into carriers whereas the absorption of the light ceases after the carriers have been accumulated to the saturation. In a two-dimensional photonic crystal laser in which such a saturable absorber section is formed within the active layer, the lasing does not begin immediately after the beginning of the injection of the electric current since the light generated within the gain section flows into the saturable absorber section and is thereby absorbed. At a later point in time when the saturable absorber section becomes saturated, the amplification of light occurs not only within the gain section but also within the saturable absorber section in which light is no longer absorbed, so that the lasing begins. The lasing within the saturable absorber section causes a decrease of the carriers within the same saturable absorber section so that the light once more begins to be absorbed within the saturable absorber section, and the lasing comes to a halt. Through the repetition of such operations, the two-dimensional photonic crystal laser disclosed in Non Patent Literature 1 repeatedly emits pulsed laser light having a short pulse width (less than one nanosecond).

In the two-dimensional photonic crystal laser disclosed in Non Patent Literature 1, an electrode in which conductive sections and non-conductive sections in the form of concentric circles are alternately created is used as one of the pair of electrodes. The non-conductive sections are created by delivering a beam of proton ions onto a conductor. A portion of the delivered proton ions penetrate through the conductor and other layers located before the active layer to ultimately reach the active layer. Consequently, saturable absorber sections having a similar shape to the non-conductive sections of the electrode are created in the active layer. The portions corresponding to the conductive sections of the electrode become the gain sections in the active layer. The gain sections and the saturable absorber sections thus created in the form of concentric circles will suppress the lasing of higher-order modes having two or more peaks in a direction parallel to the active layer, and the pulsed laser beam emitted from the two-dimensional photonic crystal laser will exhibit an intensity distribution in the form of a so-called unimodal form in which the intensity is at high levels near the center of the cross section of the beam and decreases with increasing distance from the center.

It should be noted that the area outside the outermost conductive section in the electrode may be a non-conductive section irradiated with the proton-ion beam or an area in which the aforementioned conductor is not provided. In the former case, the section of the active layer corresponding to that area will be a saturable absorber section. In the latter case, it will be neither a gain section nor a saturable absorber section, but a section in which light is simply diffused (propagated) and/or absorbed.

CITATION LIST

PATENT LITERATURE

Patent Literature 1: WO 2014/136607 A
Patent Literature 2: US 2016/0248224 A
Patent Literature 3: WO 2022/181723 A
Patent Literature 4: WO 2021/039316 A

NON PATENT LITERATURE

Non Patent Literature 1: Ryohei Morita and four other authors, "Photonic-crystal lasers with two-dimensionally arranged gain and loss sections for high-peak-power short-pulse operation", Nature Photonics, Nature Research (Great Britain), March 4, 2021, Vol. 15, pp. 311-318
Non Patent Literature 2: Ryohei Morita and nine other authors, "200-W short-pulse operation of photonic-crystal lasers based on simultaneous absorptive and radiative Q-switching", Optics Express, Optica, September 6, 2023

SUMMARY OF INVENTION

TECHNICAL PROBLEM

In the aforementioned areas, such as the sensing or material processing, a laser device configured to emit a plurality of beams of pulsed laser light in different directions has been demanded. Such a laser device produces a plurality of spots of pulsed laser light distributed over a wide area at the position of the target of the sensor or the processing material placed at a distance from the laser device, whereby the detection range of the sensor or the processing range can be expanded. However, the two-dimensional photonic crystal laser disclosed in Non Patent Literature 1 cannot emit pulsed laser light in any other direction than the direction perpendicular to the two-dimensional photonic crystal layer.
The problem to be solved by the present invention is to provide a two-dimensional photonic crystal laser that can be used for a laser device configured to emit a plurality of beams of pulsed laser light with a short pulse width (less than one nanosecond) in different directions.

SOLUTION TO PROBLEM

A two-dimensional photonic crystal laser according to the present invention developed for solving the previously described problem includes:

an active layer configured to generate light of a predetermined wavelength which is a laser emission wavelength by being injected with an electric current;
a two-dimensional photonic crystal layer including a plate-shaped base body arranged parallel to the active layer as well as modified refractive index portions arranged in the base body and having a refractive index different from the refractive index of the base body, where the modified refractive index portions are arranged with respective predetermined amounts of displacement from the lattice points of a two-dimensional lattice arrayed in two predetermined directions with a period corresponding to the predetermined wavelength, or/and, are arranged at the lattice points and have respective predetermined areas, where the amounts of displacement or/and the areas are modulated with a predetermined modulation period; and
a pair of electrodes provided so that the active layer and the two-dimensional photonic crystal layer are sandwiched between the electrodes in a direction perpendicular to the active layer and the two-dimensional photonic crystal layer, where the active layer has a saturable absorber section which is a linear section forming a portion of a predetermined range and having no portion parallel to any one of the two predetermined directions, a gain section occupying a portion other than the saturable absorber section within the predetermined range, and a non-gain section formed around the predetermined range, where the saturable absorber section is a section having a lower level of conductivity and a shorter carrier lifetime than the gain section.

Here, the "non-gain section" may be any type of section different from the gain section; it may be a section having similar properties to the saturable absorber section, or a section which is similar to neither the gain section nor the saturable absorber section and allows light to be simply diffused (propagated) and/or absorbed.

In the area of two-dimensional photonic crystal lasers which generate a continuous laser beam (and not a pulsed laser beam), a modulated two-dimensional photonic crystal laser has been known which includes a two-dimensional photonic crystal layer in which the positions at which the modified refractive index portions are arranged are displaced from the reference positions corresponding to the positions of the lattice points of a two-dimensional lattice, where the amount of displacement (a vector quantity consisting of the combination of the magnitude and direction of displacement) is modulated (changed) with a predetermined modulation period, or in which the areas of the modified refractive index portions are modulated with a predetermined modulation period (for example, see Patent Literature 1 or 2). This type of modulated two-dimensional photonic crystal laser emits a continuous laser beam inclined from the direction perpendicular to the two-dimensional photonic crystal layer to a direction determined by the modulation period. A laser device constructed by combining a plurality of such modulated two-dimensional photonic crystal lasers having different modulation periods can emit a plurality of beams of continuous laser light in different directions depending on the modulation periods. A single modulated two-dimensional photonic crystal laser can also be configured to emit a plurality of beams of continuous laser light in different directions by modulating the amount of displacement or/and the area with a composite modulation period in which a plurality of different modulation periods are superposed on each other (Patent Literature 3).

The modulated two-dimensional photonic crystal lasers disclosed in Patent Literatures 1-3 cannot emit a pulsed laser beam when used in their respective original forms. Additionally, a simulation conducted by the present inventors for the modulated two-dimensional photonic crystal lasers disclosed in Patent Literatures 1-3 in which the gain section and the saturable absorber section are alternately created in the form of concentric circles in the active layer as described in Non Patent Literature 1 has revealed that the emission will not be pulsed laser light but continuous laser light.

Accordingly, the present inventors examined the state of lasing for the previously mentioned modulated two-dimensional photonic crystal laser having the gain section and the saturable absorber section alternately created in the active layer as well as a two-dimensional photonic crystal laser configured to emit pulsed laser light as disclosed in Non Patent Literature 1 (with no modulation in the two-dimensional photonic crystal layer). The result revealed that, in the latter case, two rays of light respectively propagated in two predetermined directions in which lattice points are arranged in the two-dimensional photonic crystal layer with a period corresponding to the predetermined wavelength repeatedly change their respective propagation directions to the direction of the other ray of light, producing an amplification effect in a two-dimensional (planer) form. By comparison, in the former case, those rays of light do not change their respective propagation directions to the two aforementioned directions, and the amplification effect is produced in a one-dimensional form. In the former type of modulated two-dimensional photonic crystal laser, if the saturable absorber section has a parallel portion to any one of the two aforementioned directions, one-dimensional lasing intensively occurs in which only one of the two rays of light one-dimensionally propagated is amplified in each of the two directions, which results in a continuous, unbroken emission of laser light.

Accordingly, in the two-dimensional photonic crystal laser according to the present invention, an active layer having a linear saturable absorber section which has no portion parallel to any one of the two aforementioned directions is used to prevent the intensive amplification of the ray of light one-dimensionally propagated in one of those two directions and thereby prevent the continuous lasing. Consequently, a pulsed laser beam inclined to the direction determined by the modulation period can be obtained. The pulse width of this pulsed laser beam is as short as equal to or less than one nanosecond as in the case of the two-dimensional photonic crystal laser of Non Patent Literature 1.

For example, when the two-dimensional lattice is a square lattice having lattice points arranged with period length $a$ in each of an x direction and a y direction perpendicular to the x direction, and when the predetermined wavelength in the two-dimensional photonic crystal layer is $2^{1/2}a$ (which corresponds to a wavelength in vacuum of $2^{1/2}a \times n_{eff}$, where $n_{eff}$ is the effective refractive index of the two-dimensional photonic crystal layer), the two predetermined directions are directions inclined from the x and y directions by 45 degrees. In this case, the linear saturable absorber section should have a shape in which no portion is parallel to the directions inclined from the x and y directions by 45 degrees. For example, one or more linear saturable absorber sections which are parallel to each other may be formed parallel to either the x direction or the y direction. As another example, one or more linear saturable absorber sections parallel to the x or y direction may be provided for each of the x and y directions to form a cross-like or mesh-like shape. In this case, the saturable absorber sections extending in the x direction and those extending in the y direction may be different from each other in number and interval, and they do not need to be provided at regular intervals but may be at irregular intervals. For example, under the condition that saturable absorber sections extending in one direction are provided at substantially regular intervals, the number and interval of the saturable absorber sections provided to extend in a direction different from the former direction by 90 degrees may be appropriately adjusted to reduce the lasing in higher-order modes, or conversely, to intentionally induce the lasing in higher-order modes. Furthermore, the extending direction of the linear saturable absorber sections is not limited to the x or y direction; it may be any direction other than the direction inclined from the x and y directions by 45 degrees.

A plurality of two-dimensional photonic crystal lasers according to the present invention which have different modulation periods can be combined to obtain a laser device configured to emit a plurality of beams of pulsed laser light having a short pulse width (less than one nanosecond) in different directions.

The saturable absorber section in the active layer of the two-dimensional photonic crystal laser according to the present invention can be created by a method similar to the method disclosed in Non Patent Literature 1. That is to say, an area where a saturable absorber section is to be created is irradiated with proton ions from one of the pair of electrodes. The proton ions penetrate through the electrode and other layers located before the active layer to ultimately reach the active layer, whereby a saturable absorber section is created. It should be noted that the ions to be used for irradiation are not limited to proton ions; other ions may also be used, such as oxygen ions. The method for creating a saturable absorber section is not limited to such an ion irradiation method; any method may be used by which the area of the active layer in which a saturable absorber section is to be created can be processed so that the area will have a lower level of conductivity and a shorter carrier lifetime than the surrounding areas (the areas which will be a gain section).

In the two-dimensional photonic crystal laser according to the present invention, the amounts of displacement or/and the areas may be modulated with a composite modulation period in which a plurality of different modulation periods are superposed on each other. This enables a single modulated two-dimensional photonic crystal laser to emit a plurality of beams of pulsed laser light in different directions depending on the respective modulation periods.

The two-dimensional photonic crystal laser according to the present invention may be configured so that a second two-dimensional lattice having second lattice points arrayed with the same period as the lattice points of the aforementioned two-dimensional lattice is further provided at a position displaced from the aforementioned two-dimensional lattice, and second modified refractive index portions having a refractive index different from the refractive index of the base body are arranged at the second lattice points or with respective different amounts of displacement from the second lattice points or/and with respective different areas.

The addition of the second modified refractive index portions induces interference between the light amplified by the periodic structure formed by the (first) modified refractive index portions and the light amplified by the periodic structure formed by the second modified refractive index portions. This interference occurs in such a manner that the intensity of light is increased or decreased depending on the magnitude and direction of the displacement of the second two-dimensional lattice from the (first) two-dimensional lattice. When an interference which increases the intensity of light occurs, the intensity of the emitted pulsed laser light will also be increased. By comparison, when an interference which decreases the intensity of light occurs, the lasing will occur in a stable form over a large area in the two-dimensional photonic crystal layer as compared to the case where the second modified refractive index portions are not present, and the intensity of the emitted pulsed laser light can consequently be increased.

The two-dimensional photonic crystal laser according to the present invention may be configured so that:

an intermediate layer is provided between one of the pair of electrodes and the active layer;
a low-conductivity section having a lower level of conductivity than the other portion in the intermediate layer is created in a portion of the intermediate layer; and
the portion where the low-conductivity section is created is connected to the saturable absorber section of the active layer.

The creation of such a low-conductivity section in the intermediate layer helps an electric current to more easily flow from the one aforementioned electrode into the gain section than the saturable absorber section. Therefore, emission can be efficiently obtained in the gain section. It should be noted that the intermediate layer is not limited to a single-layered form; it may be formed by multiple layers which differ from each other in material and/or other properties. In this case, the combination of those layers should be considered as a single "intermediate layer". The intermediate layer may include the two-dimensional photonic crystal layer.

ADVANTAGEOUS EFFECTS OF INVENTION

According to the present invention, it is possible to obtain a two-dimensional photonic crystal laser that can be used for a laser device configured to emit a plurality of beams of pulsed laser light with a short pulse width (less than one nanosecond) in different directions.

BRIEF DESCRIPTION OF DRAWINGS

[Fig. 1] Fig. 1 is a perspective view showing a schematic configuration of a first embodiment of the two-dimensional photonic crystal laser according to the present invention.
[Fig. 2] Fig. 2 is a plan view showing gain sections, saturable absorber sections and a non-gain section to be created in the active layer in the two-dimensional photonic crystal laser according to the first embodiment.

[Fig. 3] Fig. 3 is a partial plan view showing the configuration of the two-dimensional photonic crystal layer in the two-dimensional photonic crystal laser according to the first embodiment.

[Fig. 4] Fig. 4 is a partial enlarged view of the two-dimensional photonic crystal layer in the two-dimensional photonic crystal laser according to the first embodiment.

[Fig. 5] Fig. 5 is a plan view showing the configuration of a first electrode in the two-dimensional photonic crystal laser according to the first embodiment.

[Fig. 6] Fig. 6 is a vertical sectional view showing conductive sections, non-conductive sections and a peripheral non-conductive section to be created in the first electrode, as well as gain sections, saturable absorber sections and a non-gain section to be created in the active layer in the two-dimensional photonic crystal laser according to the first embodiment.

[Fig. 7] Fig. 7 is a plan view showing the configuration of the first electrode in a comparative example.

[Fig. 8] Fig. 8 is a graph showing a calculated result of the temporal change in the intensity of pulsed laser light for the two-dimensional photonic crystal laser according to the first embodiment.

[Fig. 9] Fig. 9 is a graph showing a calculated result of the temporal change in the intensity of laser light for the two-dimensional photonic crystal laser according to the comparative example.

[Fig. 10] Fig. 10 is images showing calculated results of a near-field pattern (left panel) and a far-field pattern (right panel) of a pulsed laser beam for the two-dimensional photonic crystal laser according to the first embodiment.

[Fig. 11] Fig. 11 is images showing calculated results of a near-field pattern (left panel) and a far-field pattern (right panel) of a laser beam for the two-dimensional photonic crystal laser according to the comparative example.

[Fig. 12] Fig. 12 is graphs showing calculated results of the temporal change in the intensity of laser light for two modified examples having different arrangement periods of the non-conductive sections in the two-dimensional photonic crystal laser according to the first embodiment.

[Fig. 13] Fig. 13 is graphs showing calculated results of the temporal change in the intensity of laser light for two modified examples having different widths of the non-conductive sections in the two-dimensional photonic crystal laser according to the first embodiment.

[Fig. 14] Fig. 14 is images showing calculated results of near-field patterns and far-field patterns of a laser beam for two modified examples having different directions of extension of the non-conductive sections in the two-dimensional photonic crystal laser according to the first embodiment.

[Fig. 15] Fig. 15 is a diagram showing a modified example of the first electrode in the two-dimensional photonic crystal laser according to the first embodiment.

[Fig. 16] Fig. 16 is a diagram showing another modified example of the first electrode in the two-dimensional photonic crystal laser according to the first embodiment.

[Fig. 17] Fig. 17 is a perspective view showing a schematic configuration of a second embodiment of the two-dimensional photonic crystal laser according to the present invention, and a partial plan view showing the configuration of the two-dimensional photonic crystal layer in the two-dimensional photonic crystal laser according to the second embodiment.

[Fig. 18] Fig. 18 is a diagram for explaining the light-amplifying effect in the two-dimensional photonic crystal layer of the two-dimensional photonic crystal laser according to the second embodiment.

[Fig. 19] Fig. 19 is a graph showing a calculated result of the temporal change in the intensity of pulsed laser light for the two-dimensional photonic crystal laser according to the second embodiment.

[Fig. 20] Fig. 20 is an image showing a calculated result of an emission pattern of a pulsed laser beam as well as its partial enlarged image for the two-dimensional photonic crystal laser according to the second embodiment.

[Fig. 21] Fig. 21 is graphs showing calculated results of the temporal change in the intensity of laser light for five modified examples having different arrangement periods of the non-conductive sections in the two-dimensional photonic crystal laser according to the second embodiment.

[Fig. 22] Fig. 22 is graphs showing calculated results of the temporal change in the intensity of laser light for two modified examples having different widths of the non-conductive sections in the two-dimensional photonic crystal laser according to the second embodiment.

[Fig. 23] Fig. 23 is a microphotograph of the first electrode in a created two-dimensional photonic crystal laser according to the second embodiment.

[Fig. 24] Fig. 24 is a photograph of a near-field pattern of a pulsed laser beam for a created two-dimensional photonic crystal laser according to the second embodiment.

[Fig. 25] Fig. 25 is a photograph of a far-field pattern of a pulsed laser beam and its partial enlarged photograph for a created two-dimensional photonic crystal laser according to the second embodiment.

[Fig. 26] Fig. 26 is a graph showing the result of an experiment in which the temporal change in the intensity of pulsed laser light was determined for a created two-dimensional photonic crystal laser according to the second embodiment.

[Fig. 27] Fig. 27 is a graph showing the result of an experiment in which the relationship between the magnitude of a supplied electric current and the peak value (peak power) of the intensity of a pulsed laser beam was determined for a created two-dimensional photonic crystal laser according to the second embodiment.

[Fig. 28] Fig. 28 is a graph showing the result of an experiment in which the relationship between the magnitude of a supplied electric current and a pulse repetition frequency was determined for a created two-dimensional photonic crystal laser according to the second embodiment.

[Fig. 29] Fig. 29 a graph showing a calculated result of the relationship of the peak power with the magnitude of the electric current injected into the active layer and the lifetime of carriers in the saturable absorber section.

[Fig. 30] Fig. 30 is a graph showing the result of an experiment in which the relationship between the magnitude of the supplied electric current and the peak power was determined for an example in which the thickness of the saturable absorber section was larger (the ion injection depth into the active layer was deeper) than in the example of Fig. 27.

[Fig. 31] Fig. 31 is an optical microphotograph of the first electrode in a created modified example of the second embodiment.

[Fig. 32] Fig. 32 is a plan view showing the saturable absorber sections and other sections to be created in the active layer in a modified example of the second embodiment.

[Fig. 33] Fig. 33 is an electron micrograph of the two-dimensional photonic crystal layer in a created modified example of the second embodiment.

[Fig. 34] Fig. 34 is a photograph of a far-field pattern of a pulsed laser beam for the two-dimensional photonic crystal laser in a created modified example of the second embodiment.

[Fig. 35] Fig. 35 is a graph showing the result of an experiment in which the temporal change in the intensity of laser light was determined for the two-dimensional photonic crystal laser in a created modified example of the second embodiment.

[Fig. 36] Fig. 36 is a graph showing an example of the temporal change in the intensity of an electric current to be injected into a two-dimensional photonic crystal laser according to the present embodiment in order to emit a single pulse of pulsed laser light.

[Fig. 37] Fig. 37 is a graph showing a calculated result of the temporal change in the intensity of the pulsed laser light observed when the electric current shown in Fig. 36 is injected in the two-dimensional photonic crystal laser according to the second embodiment.

[Fig. 38] Fig. 38 is a diagram showing a measured result obtained by measuring, with an oscilloscope, the intensity of a pulsed electric current injected for emitting a single pulse of pulsed laser light from a created two-dimensional photonic crystal laser according to the second embodiment, as well as a measured result obtained by measuring, with a photodiode, the intensity of the thereby obtained single pulse of the pulsed laser beam.

[Fig. 39] Fig. 39 is a graph showing a measured result obtained by measuring, with a streak camera, the intensity of the pulsed laser beam shown in Fig. 38.

[Fig. 40] Fig. 40 is a schematic configuration diagram showing an example of a laser device provided with a plurality of two-dimensional photonic crystal lasers according to the first or second embodiment which differ from each other in the amount of displacement from the lattice points of a two-dimensional lattice or/and in the area of the modified refractive index portion.

[Fig. 41] Fig. 41 is a perspective view showing another example of a laser device provided with a plurality of two-dimensional photonic crystal lasers according to the first or second embodiment which differ from each other in the amount of displacement from the lattice points of a two-dimensional lattice or/and in the area of the modified refractive index portion.

[Fig. 42] Fig. 42 is a plan view showing an example of the variation in period length depending on the position in the two-dimensional photonic crystal layer in a two-dimensional photonic crystal laser according to a reference example.

[Fig. 43] Fig. 43 is graphs showing the results of an experiment in which the temporal change in the intensity of pulsed laser light was determined for a two-dimensional photonic crystal laser according to a reference example.

[Fig. 44] Fig. 44 is a plan view showing an example of the variation in area depending on the position in the two-dimensional photonic crystal layer in a two-dimensional photonic crystal laser according to a reference example.

DESCRIPTION OF EMBODIMENTS

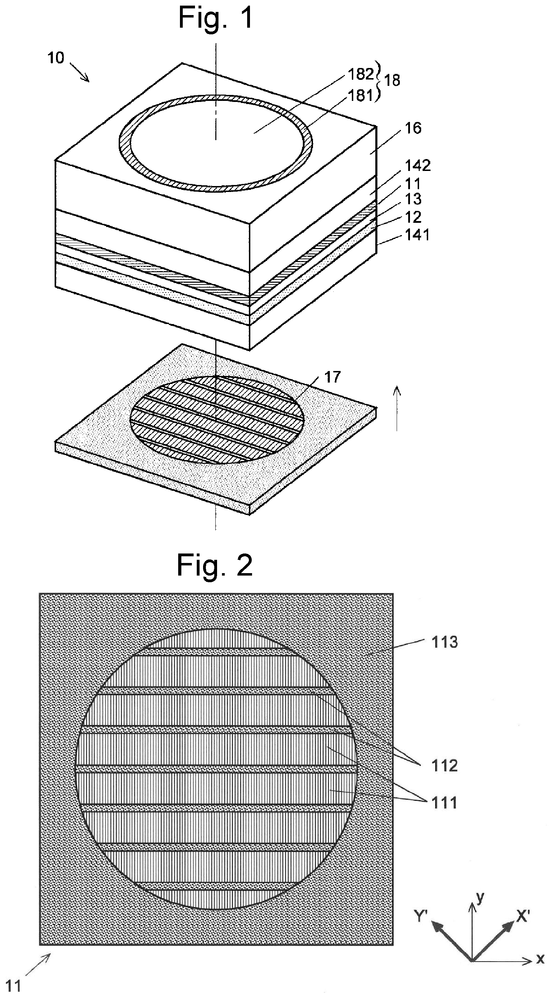

Embodiments of the two-dimensional photonic crystal laser according to the present invention are described using Figs. 1-41.

(1) Two-dimensional photonic crystal laser according to first embodiment

(1-1) Configuration of two-dimensional photonic crystal laser according to first embodiment

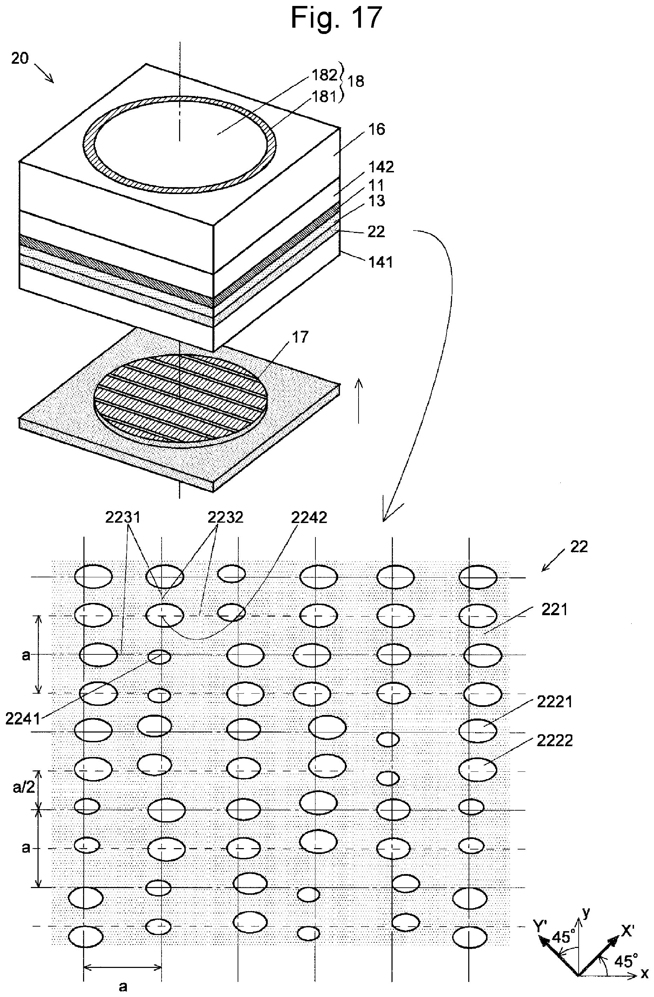

As shown in Fig. 1, a two-dimensional photonic crystal laser 10 according to the first embodiment has a configuration which includes a first electrode 17, first cladding layer 141, two-dimensional photonic crystal layer 12, spacer layer 13, active layer 11, second cladding layer 142, substrate 16, and second electrode 18 sequentially stacked in this order. It should be noted that the order of the active layer 11 and the two-dimensional photonic crystal layer 12 may be opposite to the aforementioned order. For convenience, the first electrode 17 and the second electrode 18 in Fig. 1 are illustrated on the lower and upper sides, respectively. However, the orientation of the two-dimensional photonic crystal laser 10 in use is not limited to the illustrated example. Furthermore, for convenience, the first electrode 17 depicted in Fig. 17 is separated downward from the first cladding layer 141; actually, the first electrode 17 is in contact with the lower side of the first cladding layer 141. The configuration of each of those layers and electrodes is hereinafter described.

The active layer 11 is a layer which emits light having a predetermined wavelength band when electric charges are injected from the first electrode 17 and the second electrode 18. As the material active layer 11, for example, an InGaAs/AlGaAs multiple quantum well (emission wavelength band: 935-945 nm) can be used.

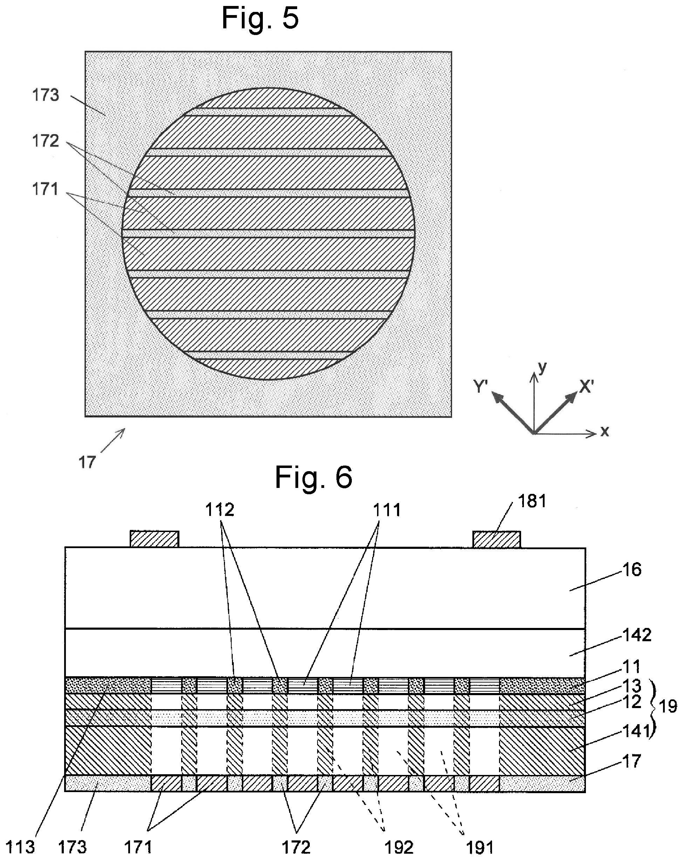

Three types of sections are created in the active layer 11, i.e., gain sections 111, saturable absorber sections 112, and a non-gain section 113 (see, Figs. 2 and 6). Details of those sections will be described later with the description of the first electrode 17.

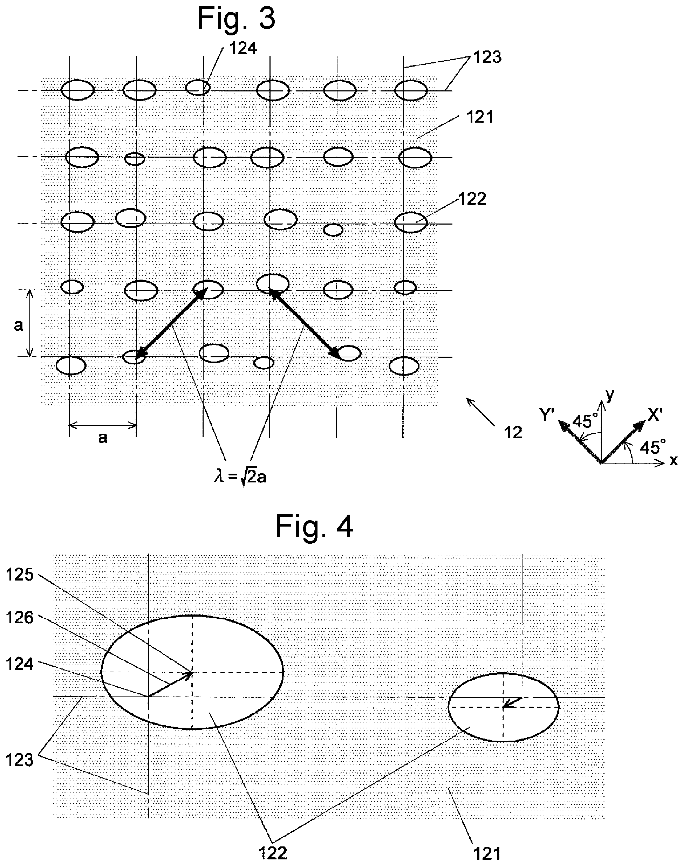

As shown in Fig. 3, the two-dimensional photonic crystal layer 12 consists of a plate-shaped base body 121 in which modified refractive index portions 122 having a refractive index different from that of the base body 121 are arranged at the lattice points 124 of a two-dimensional lattice 123, with one modified refractive index portion at each lattice point. It should be noted that only a portion of the two-dimensional photonic crystal layer 12 is shown in an enlarged form in Fig. 3. As the material of the base body 121, for example, p-type GaAs (p-type semiconductor) can be used. The modified refractive index portions 122 typically consist of holes (air) provided in the base body 121. Alternatively, they may be created by embedding, in the base body 121, members having a refractive index different from that of the base body 121.

The planer shape of the modified refractive index portions 122 in the present embodiment is elliptic, but they may be shaped in various forms, such as a circle, equilateral triangle or other types of triangles, as well as polygons other than triangles. Although the two-dimensional lattice 123 in the present embodiment is a square lattice, other types of two-dimensional lattices may also be used, such as a rectangular lattice or triangular lattice. The length $a$ of the period of the lattice points (period length) of the two-dimensional lattice 123 is determined according to the material of the base body 121 and the emission wavelength in the active layer 11. In the present embodiment, the period length $a$ is determined so that the value of $a$ multiplied by $2^{1/2}$ ($2^{1/2}a$) will be equal to the wavelength $\lambda$ which the light generated in the active layer 11 will have in the two-dimensional photonic crystal layer 12. When the effective refractive index of the two-dimensional photonic crystal layer 12 is $n_{\text{eff}}$, the light having wavelength $\lambda$ in the two-dimensional photonic crystal layer 12 will have wavelength $\lambda_0$ in vacuum which equals $\lambda \times n_{\text{eff}}$, i.e., $2^{1/2}a \times n_{\text{eff}}$. Let the two directions in which the lattice points 124 are arrayed with period length $a$ in the two-dimensional lattice 123 be defined as the x and y directions. This two-dimensional photonic crystal layer 12 amplifies rays of light having wavelength $\lambda$ and travelling in two directions respectively inclined to the x and y directions by 45 degrees (those two directions are hereinafter called the "X' direction" and the "Y' direction", respectively). It should be noted that the modified refractive index portions 122 which have an elliptic shape as noted earlier are arranged so that the longer and shorter diameters of the ellipse are directed in the x and y directions, respectively.

In the present embodiment, as shown in the enlarged view in Fig. 4, each modified refractive index portion 122 is arranged in such a manner that the center (centroid) 125 of its planer shape is displaced from the corresponding lattice point 124 of the two-dimensional lattice 123. The magnitude and direction of that displacement are hereinafter collectively called the "amount of displacement". In Fig. 4, the amount of displacement is represented by a vector 126. The amount of displacement varies for each lattice point 124. Furthermore, in the present embodiment, the area of the planer shape of the modified refractive index portion 122 also varies for each modified refractive index portion 122 (lattice point 124). The amount of displacement and the area change with a predetermined period along each of the x and y directions. The period of this change in the amount of displacement or/and the area is called the "modulation period", and the amount of displacement or/and the area at each modified refractive index portion modulated with that modulation period is called the "modulation phase". A period in which a plurality of different modulation periods are superposed on each other is called the "composite modulation period", and the amount of displacement or/and the area at each modified refractive index portion modulated with this composite modulation period is called the "composite modulation phase".

As described in Patent Literatures 1-3, the modulation phase or composite modulation phase is a parameter which affects the emitting direction of the laser beam to be emitted from a common type of modulated two-dimensional photonic crystal laser. This also applies in the present embodiment; the emitting direction of the pulsed laser beam to be emitted from the two-dimensional photonic crystal laser 10 depends on the modulation phase or composite modulation phase. The following descriptions initially deal with the composite modulation phase, followed by descriptions of the modulation phase as a special example of the composite modulation phase.

As described in Patent Literature 3, the composite modulation phase $\psi(r\uparrow)$, where $r\uparrow$ is a vector representing the position of the lattice point 124, is expressed as follows, using vectors $k\uparrow$ and $k_n\uparrow$ which will be described later:
[Formula 1]

$$\Psi\left(r\uparrow\right)=\arg\left[\int\int\sum_{n}c_{n}\delta\left(k\uparrow-k_{n}\uparrow\right)\exp\left(ik\uparrow\cdot r\uparrow\right)dk\uparrow\right]\quad\cdots(1)$$

In equation (1), "arg" is the angle of deviation of the complex number. $c_n$ is expressed by:
[Formula 2]

$$c_{n}=A_{n}\exp\left(i\alpha_{n}\right)\quad\cdots(2)$$

In equation (2), $A_n$ is the amplitude, and $\alpha_n$ is the phase.

Back to equation (1), $k_n\uparrow$ is a vector expressed using the inclination angle $\theta_n$ (the angle of inclination of the pulsed laser beam from the normal to the two-dimensional photonic crystal layer 12) and the azimuth angle $\varphi_n$ (the angle representing the direction, in a plane parallel to the two-dimensional photonic crystal layer 12, of the projection of the pulsed laser beam onto the same plane) of the pulsed laser beam to be emitted, as well as the effective refractive index $n_{eff}$ of the two-dimensional photonic crystal layer 12. $\delta(k\uparrow-k_n\uparrow)$ is a delta function: $\delta(k\uparrow-k_n\uparrow)=1$ when $k\uparrow=k_n\uparrow$, otherwise $\delta(k\uparrow-k_n\uparrow)=0$.

When the two-dimensional lattice is a square lattice of period length $a$ as in the present embodiment, $k_n\uparrow$ is expressed as follows:
[Formula 3]

$$k_{n}\uparrow=\left(\left(\frac{1}{2}-\frac{1}{\sqrt{2}n_{eff}}\sin\theta_{n}\cos\phi_{n}\right)\frac{2\pi}{a}\;,\;\left(\frac{1}{2}-\frac{1}{\sqrt{2}n_{eff}}\sin\theta_{n}\sin\phi_{n}\right)\frac{2\pi}{a}\right)$$

$$\cdots(3)$$

From these equations (1)-(3), the two-dimensional photonic crystal laser 10 in which the two-dimensional photonic crystal layer 12 has a composite modulation phase $\psi(r\uparrow)$ expressed by equation (1) emits n pulsed laser beams with different inclination angles $\theta$ and/or azimuth angles $\varphi$ (actually, each of those $n$ pulsed laser beams is accompanied by the emission of an additional pulsed laser beam which is identical in inclination angle to the pulsed laser beam concerned and has a 180-degree difference in azimuth angle). A case in which there is only one combination of the inclination angle $\theta_n$ and the azimuth angle $\varphi_n$ (only n=1) in equations (1)-(3) corresponds to the modulation phase mentioned earlier. Through the modulation phase or composite modulation phase, it is possible to specify the amount of displacement or/and the area at each lattice point.

Although both of the amount of displacement and the area were varied for each modified refractive index portion 122 (lattice point 124) in the present embodiment, it is also possible to only vary either the amount of displacement or the area for each modified refractive index portion 122 (lattice point 124).

The first cladding layer 141 and the second cladding layer 142 have the function of injecting electric charges from the first electrode 17 and the second electrode 18, as well as the function of preventing the in-plane propagated light traveling within and parallel to the two-dimensional photonic crystal layer 12 from leaking from this layer. In order to achieve the former function, a p-type semiconductor (e.g., p-type $Al_{0.37}Ga_{0.63}As$) is used as the first cladding layer 14, while an n-type semiconductor (e.g., n-type $Al_{0.37}Ga_{0.63}As$) is used as the second cladding layer 142 (this same reason also applies for the use of a p-type semiconductor as the material of the base body 121 of the two-dimensional photonic crystal layer 12).

The spacer layer 13 is provided for allowing positive holes injected from the first electrode 17 to pass through and be introduced into the active layer 11 while preventing electrons injected from the second electrode 18 from passing through the active layer 11 (and thereby combining with positive holes on the side of the active layer 11 facing the first electrode 17). For example, p-type $Al_{0.45}Ga_{0.55}As$ can be used as the material of the spacer layer 13.

The substrate 16 should be sufficiently thick as compared to the other layers in order to maintain the mechanical strength of the entire two-dimensional photonic crystal laser 10. The material used for the substrate 16 should be an n-type semiconductor for the same reason as explained for the second cladding layer 142.

As shown in Fig. 5, the first electrode 17 has linear non-conductive sections 172 created in portions of a circular range, conductive sections 171 occupying the portions other than the non-conductive sections 172 in the circular range, and a square peripheral non-conductive section 173 created around the circular range. There are multiple non-conductive sections 172 extending in the x direction (which is a direction inclined to both X' and Y' directions by 45 degrees), being separated from each other in the y direction. The non-conductive sections 172 do not have any portion parallel to the X' or Y' direction. The first electrode 17 can be created by injecting hydrogen ions or similar ions a plate material made of a conductor to make non-conductive portions at which the non-conductive sections 172 and the peripheral non-conductive section 173 should be created. Alternatively, ions may be injected into the non-conductive sections 172 in a plate material having the same shape as the circular range. In this case, the peripheral non-conductive section 173 is not provided. The shape of the non-conductive sections 172 presented here is a mere example; it is possible to use non-conductive sections 172 in various shapes as long as they do not have any portion parallel to the X' or Y' direction (details will be described later). Although the combined shape of the conductive sections 171 and the non-conductive sections 172 in the present embodiment is circular, they may also have other types of shapes. The shape of the peripheral non-conductive section 173 is not limited to a square as in the present embodiment; it may have various shapes, such as a circular shape.

When hydrogen ions or similar ions are injected into portions at which non-conductive sections 172 should be created in the aforementioned manner, a portion of those ions penetrates through the first electrode 17, first cladding layer 141, two-dimensional photonic crystal layer 12 and spacer layer 13, to reach the active layer 11. Consequently, in the active layer 11, the ions are injected into the sections corresponding to the non-conductive sections 172 of the first electrode 17, causing the conductivity of those sections to be lower than that of the other sections of the active layer 11 as well as reducing the lifetime of carriers which will be generated when light is absorbed into those sections. Thus, those sections become saturable absorber sections 112 (see Figs. 2 and 6). On the other hand, the sections of the active layer 11 corresponding to the conductive sections 171 of the first electrode 17 do not receive the ions and will be gain sections 111 (see also the aforementioned figures). Furthermore, the section outer than the circular range formed by the combination of the gain sections 111 and the saturable absorber sections 112 will be a section having similar properties to the saturable absorber sections 112 in the case where the peripheral non-conductive section 173 is created in the first electrode 17, whereas it will not have such properties in the case where the peripheral non-conductive section 173 is not created. In any case, the section will not be a gain section since no electric current is injected. Therefore, that outer section is called the "non-gain section 113" (see the aforementioned figures).

In the process of creating the saturable absorber sections 112 in the active layer 11 by the injection of ions in the previously described manner, some ions are also trapped at sections where ions are expected to pass through (the sections denoted by reference sign 192 in Fig. 6) in the first cladding layer 141, two-dimensional photonic crystal layer 12 and spacer layer 13 located between the first electrode 17 and the active layer 11 (those layers are collectively called the "intermediate layer 19"). Consequently, the sections 192 which ions have passed through in the intermediate layer 19 also have lower levels of conductivity than the other sections of the same layer. Those sections 192 are called the "low-conductivity sections 192". The low-conductivity sections 192 are formed so that they connect the non-conductive sections 172 of the first electrode 17 and the saturable absorber sections 112 of the active layer 11. On the other hand, the sections between the low-conductivity sections 192 (high-conductivity sections 191) have higher levels of conductivity than the low-conductivity sections 192 and are formed so that they connect the conductive sections 171 of the first electrode 17 and the gain sections 111 of the active layer 11. The high-conductivity sections 191 and the low-conductivity sections 192 have the function of selectively introducing an electric current flowing between the first electrode 17 and the second electrode into the gain sections 111 rather than the saturable absorber sections 112 in the active layer 11.

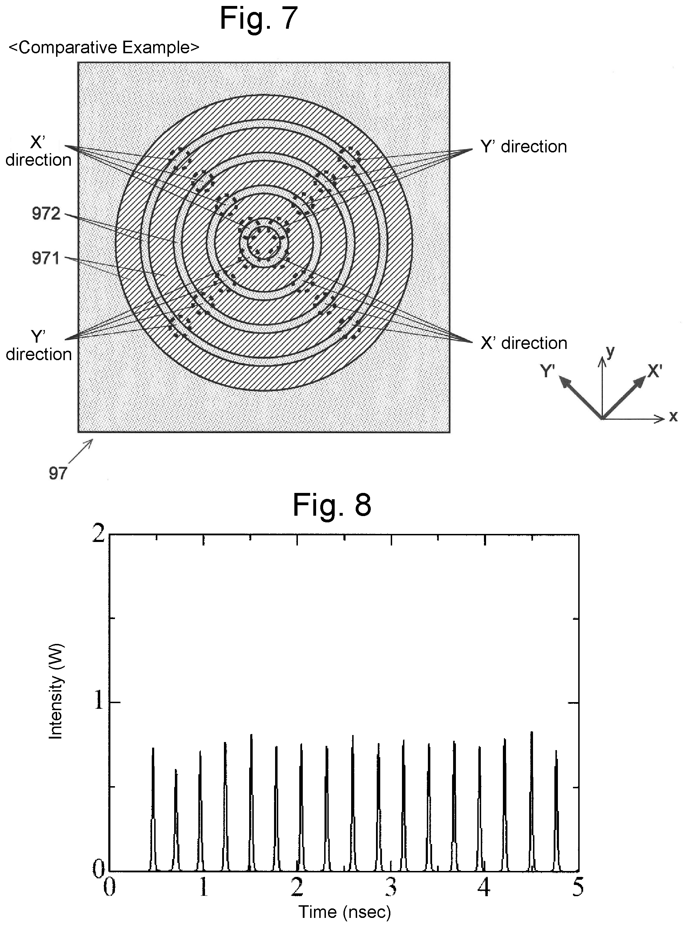

As shown in a comparative example in Fig. 7, an electrode 97 consisting of a plate material made of a conductor with linear non-conductive sections 972 created in the form of concentric circles (with conductive sections 971 and non-conductive sections 972 alternately created in the form of concentric circles) cannot be used as the first electrode in the present embodiment since it has portions parallel to the X' direction as well as portions parallel to the Y' direction (the portions surrounded by the broken circles in Fig. 7) in the circumference of the non-conductive sections 972.

The second electrode 18 has the configuration of a circular plate material made of a conductor with its central area removed in a circular form. The removed portion of the plate material is called the window portion 182, while the remaining portion of the plate material is called the frame portion 181. The window portion 182 is provided for allowing a pulsed laser beam generated from the two-dimensional photonic crystal layer 12 to pass through. The overall shape of the second electrode 18 may be different from a circular shape, although it is preferable that the shape should be similar to the overall shape of the first electrode 17.

The first cladding layer 141 is sufficiently thinner than the second cladding layer 142. Therefore, the distance between the active layer 11 and the first electrode 17 is sufficiently shorter than the distance between the active layer 11 and the second electrode 18. Accordingly, when an electric current is passed between the first electrode 17 and the second electrode 18, the distribution of the electric current in the active layer 11 will be close to the shape of the conductive sections 171 of the first electrode 17.

(1-2) Operation of two-dimensional photonic crystal laser according to first embodiment

The two-dimensional photonic crystal laser 10 according to the first embodiment operates as follows when an electric current is passed between the first electrode 17 and the second electrode 18: When the injection of the electric current is initiated, light having a predetermined wavelength is generated in the gain sections 111 of the active layer 11. In this process, the electric current (positive holes) injected from the first electrode 17 mostly flows through the high-conductivity sections 191 into the gain sections 111 connected to those high-conductivity sections. Accordingly, the positive holes can be efficiently injected into the gain sections 111.

The light generated in the gain sections 111 is initially absorbed by the saturable absorber sections 112 and is thereby converted into electron-hole pairs (carriers). A further continuation of the injection of the electric current causes the saturable absorber sections 112 to be unable to absorb light due to the accumulation of the carriers. Consequently, light is introduced from not only the gain sections 11 but also the saturable absorber sections 112 into the two-dimensional photonic crystal layer 12. This light is amplified by the periodic structure of the two-dimensional photonic crystal layer 12. Thus, the light is amplified into laser light over a wide range including the gain sections 111 and the saturable absorber sections 112 combined together. The generated laser light emits in the form of 2n laser beams with inclination angles of $\theta_n$ and azimuth angles of $\varphi_n$ and ($\varphi_n$+180 degrees) determined by the modulation phase or composite modulation phase of the two-dimensional photonic crystal layer 12.

The amplification of light in the saturable absorber sections 112 causes a rapid decrease in the carriers accumulated in the saturable absorber sections 112, so that the amplification of light ceases in a short period of time. Consequently, the laser beam also ceases in a short period of time. Then, the accumulation of carriers in the saturable absorber sections 112 once more occurs, causing an emission of 2n laser beams through a similar process to the previously described one, followed by the cease of the laser beams in a short period of time. By repeating the operations described so far, the two-dimensional photonic crystal laser 10 according to the first embodiment repeatedly emits 2n pulsed laser beams inclined to the normal to the two-dimensional photonic crystal layer 12.

Next, the result of a calculation is described in which the temporal change in the intensity of the emitted laser light and the intensity distribution at a section of the laser beam were calculated for the two-dimensional photonic crystal laser 10 according to the first embodiment as well as the two-dimensional photonic crystal laser according to the comparative example having the electrode 97 shown in Fig. 7 in place of the first electrode 17. In the calculation for the two-dimensional photonic crystal laser 10, it was assumed that the diameter of the entire first electrode 17 was 150 μm, the width of each non-conductive section 172 was 2.75 μm, and seven non-conducive sections 172 were arranged with a period of 22 μm. For the two-dimensional photonic crystal laser according to the comparative example, it was assumed that the diameter of the entire electrode 97 was 150 μm (as with the case of the first embodiment), the width of each non-conductive section 972 was 2.75 μm (same as above), and four non-conducive sections 972 were arranged in the form of concentric circles with a period of 35 μm. As for the two-dimensional photonic crystal layer 12, which was common to both the first embodiment and the comparative example, the modulation phase was set so that inclined pulsed laser beams would be emitted with an inclination angle of $\theta$=54 degrees and azimuth angles of $\varphi$=0 degrees and 180 degrees.

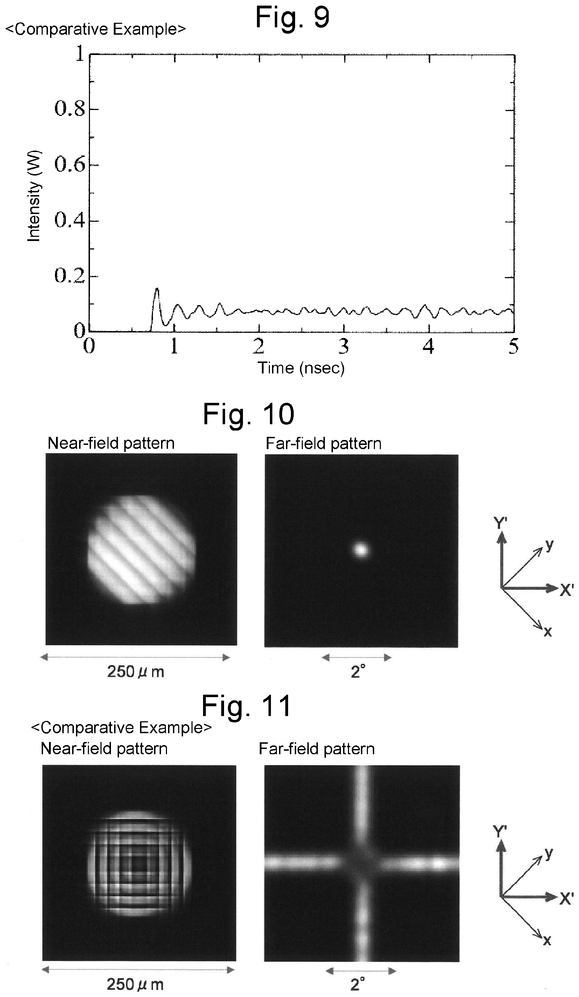

The calculated results of the temporal change in the intensity of the laser light for the first embodiment and the comparative example are shown by graphs in Figs. 8 and 9, respectively. The horizontal axis of the graphs is the elapsed time from the beginning of the injection of the electric current, while the vertical axis is the intensity of the laser light. The two-dimensional photonic crystal laser 10 according to the first embodiment repeatedly generates pulsed laser light with a pulse repetition period of approximately 0.3 nanoseconds and a pulse width of approximately 20 to 30 picoseconds. By comparison, the two-dimensional photonic crystal laser according to the comparative example continuously generates laser light with an intensity which is one order of magnitude lower than in the first embodiment; no pulsed laser light is obtained.

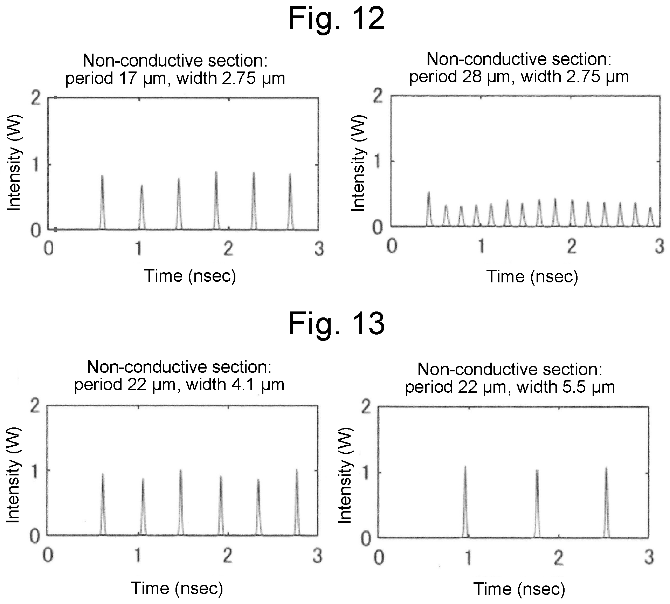

The calculated results of the intensity distribution at a section of the laser beam for the first embodiment and the comparative example are shown in Figs. 10 and 11, respectively. In both Figs. 10 and 12, the left panel shows the intensity distribution near the second electrode 18 (near-field pattern) while the right panel shows the intensity distribution at a sufficiently distant position from the second electrode 18 (far-field pattern). In both cases, two pulsed laser beams are actually emitted with the same inclination angle and 180-degree different azimuth angles, and only one of the two beams is shown in Figs. 10 and 11. In both figures, the X' direction and the Y' direction are respectively shown as the horizontal direction and the vertical direction (in a direction rotated from the direction of Figs. 3-7 by -45 degrees).

It can be seen that, in the two-dimensional photonic crystal laser 10 according to the first embodiment, a unimodal intensity distribution in which the intensity is highest at the center of the beam section is obtained, particularly in the far-field pattern. By comparison, in the two-dimensional photonic crystal laser according to the comparative example, the beam section is elongated over an area extending in a one-dimensional form in each of the X' and Y' directions, particularly in the far-field pattern. Such an intensity distribution in the comparative example demonstrates that a one-dimensional oscillation occurs in which only a ray of light linearly propagated in each of the two directions is amplified. The occurrence of such a one-dimensional oscillation is most likely to be the cause of the continuous, unbroken emission of the laser light in the two-dimensional photonic crystal laser according to the comparative example.

The shape of the first electrode 17 is not limited to the previously described example. For example, by a calculation of the temporal change in the intensity of the laser light performed for variations of the two-dimensional photonic crystal laser 10 in which the arrangement period of the non-conductive sections 172 was respectively changed from 22 μm to 17 μm and 28 μm (with no change in the width from 2.75 μm), it was confirmed that, as shown in Fig. 12, pulsed laser light was generated in both cases. Elongating the arrangement period of the non-conductive sections 172 shortens the pulse repetition period as well as decreases the peak value of the intensity per one pulse.

Next, by a calculation of the temporal change in the intensity of the laser light performed for variations of the two-dimensional photonic crystal laser 10 in which the width of the non-conductive sections 172 was respectively changed from 2.75 μm to 4.1 μm and 5.5 μm (with no change in the arrangement period of the non-conductive sections 172 from 22 μm), it was confirmed that, as shown in Fig. 13, pulsed laser light was generated in both cases. Increasing the width of the non-conductive sections 172 elongates the pulse repetition period. The peak values of the intensity per one pulse in the cases where the width of the non-conductive sections 172 was 4.1 μm and 5.5 μm were larger than in the case of 2.75 μm (there was no significant difference between the case of 4.1 μm and that of 5.5 μm).

Although only either the arrangement period of the non-conductive sections 172 (and the saturable absorber sections 112) or the width of the non-conductive sections 172 (same as above) was changed in the examples of Figs. 12 and 13, it is possible to change both of them.

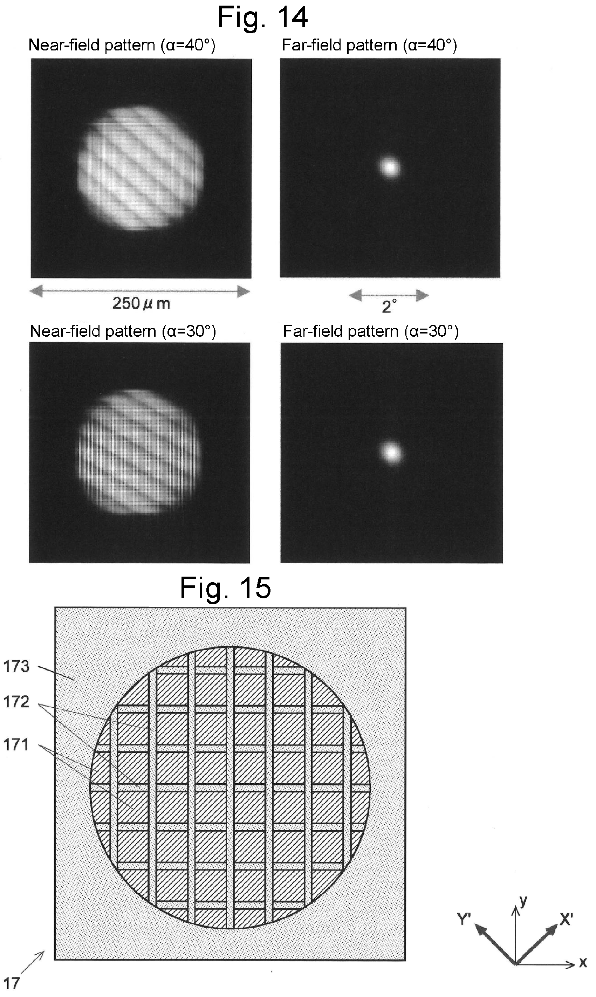

In the previously described two-dimensional photonic crystal laser 10, the direction in which the non-conductive sections 172 extend was a direction inclined to the X' and Y' directions by 45 degrees. The direction may extend in any other direction as long as it is parallel to neither the X' direction nor the Y' direction. Fig. 14 shows the result of a calculation of the near-field pattern and the far-field pattern of a laser beam for examples in which the non-conductive sections 172 were inclined to the X' direction by an angle α of 40 degrees (and 50 degrees to the Y' direction) or 30 degrees (and 60 degrees to the Y' direction). The pulsed laser oscillation was obtained in any of these examples. The near-field and far-field patterns were similar to the examples in which the extending direction of the non-conductive sections 172 was inclined to the X' and Y' directions by 45 degrees. The far-field pattern confirms that an approximately unimodal intensity distribution can be obtained.

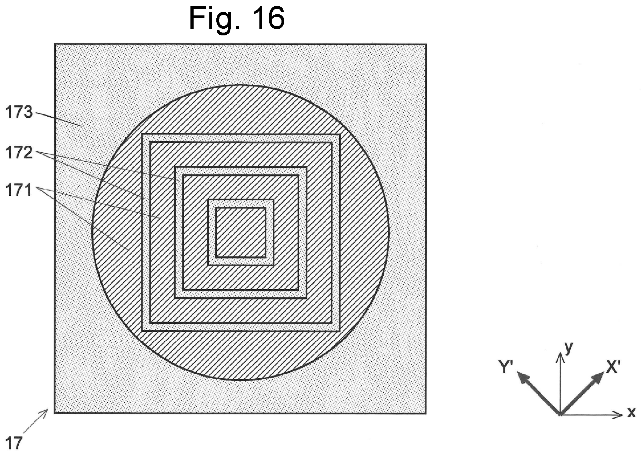

Although the descriptions so far have been concerned with the case where the first electrode 17 (and the active layer 11) has rectilinear non-conductive sections 172 (and saturable absorber sections 112), the shape of the non-conductive sections (and the saturable absorber sections 112) may be any shape as long as it does not have any portion parallel to the X' or Y' direction. For example, as shown in Fig. 15, rectilinear non-conductive sections 172 extending in the x and y directions (each direction being inclined to the X' and Y' directions by 45 degrees) may be provided in a grid-like form. As another example, as shown in Fig. 16, a plurality of non-conductive sections 172 in the form of rectangular (square) frames may be concentrically provided, with each frame having a different side length and the four sides extending in the x or y direction. In both examples of Fig. 15 and 16, the non-conductive sections 172 may be formed to be inclined from the x and/or y direction provided that they are parallel to neither the X' direction nor the Y' direction.

(2) Two-dimensional photonic crystal laser according to second embodiment

A two-dimensional photonic crystal laser 20 according to the second embodiment has a similar configuration to the two-dimensional photonic crystal laser 10 according to the first embodiment except that the configuration of the two-dimensional photonic crystal layer 22 is different from that of the two-dimensional photonic crystal layer 12 in the first embodiment. Therefore, the components other than the two-dimensional photonic crystal layer 22 are shown in the perspective view in Fig. 17 by reference signs identical to those used for the components of the two-dimensional photonic crystal laser 10 according to the first embodiment, and detailed descriptions of those components will be omitted. Hereinafter, the configuration of the two-dimensional photonic crystal layer 22 is described using the plan view in Fig. 17.

The two-dimensional photonic crystal layer 22 consists of a plate-shaped base body 221 in which first modified refractive index portions 2221 having a refractive index different from that of the base body 221 are arranged at the lattice points 2241 of a first two-dimensional lattice 2231, with one first modified refractive index portion at each lattice point, and second modified refractive index portions 2222 having a refractive index different from that of the base body 221 are arranged at the lattice points 2242 of a second two-dimensional lattice 2232, with one second modified refractive index portion at each lattice point. Both the first two-dimensional lattice 2231 and the second two-dimensional lattice 2232 are a square lattice formed by the first lattice points 2241 and the second lattice points 2242 arrayed in the x and y directions with period length $a$. The second two-dimensional lattice 2232 is displaced from the first two-dimensional lattice 2231 by $a/2$ in the y direction. In the x direction, there is no displacement between the first two-dimensional lattice 2231 and the second two-dimensional lattice 2232. Each of the first modified refractive index portions 2221 is arranged with the amount of displacement from the corresponding first lattice point 2241 or/and the area modulated with a predetermined modulation period or composite modulation period. Similarly, each of the second modified refractive index portions 2222 is arranged with the amount of displacement from the corresponding second lattice point 2242 or/and the area modulated with a predetermined modulation period or composite modulation period. The modulation period or composite modulation period of the first modified refractive index portions 2221 may be the same as or different from that of the second modified refractive index portions 2222. The second modified refractive index portions 2222 may be arranged without modulation.

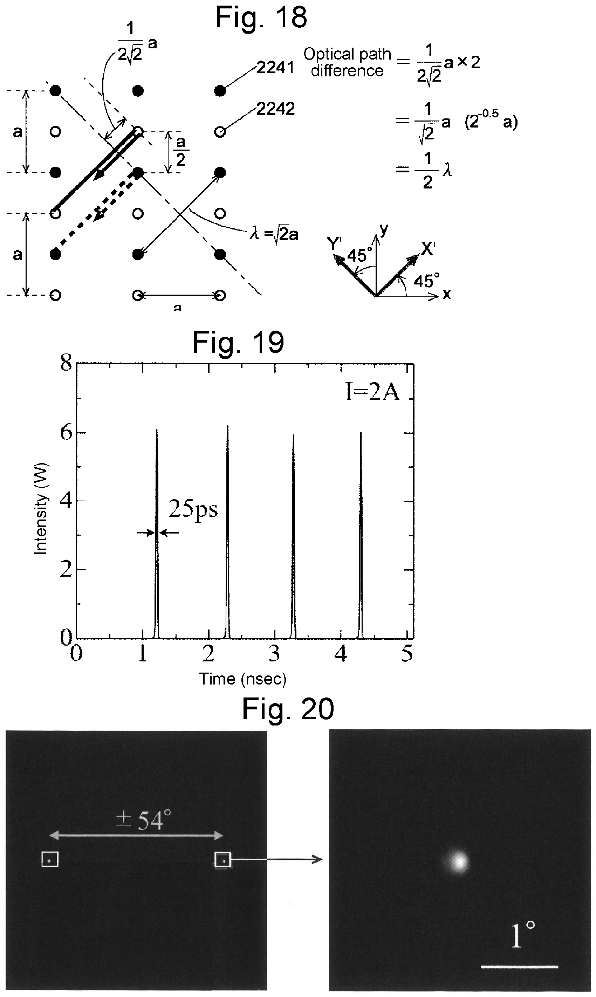

The light-amplifying effect in the two-dimensional photonic crystal layer 22 having such a configuration is described. Among the rays of light of wavelength $\lambda = 2^{1/2}a$ generated within the active layer 11 and propagated in the X' or Y' direction in the two-dimensional photonic crystal layer 22, a first ray of light reflected at a first modified refractive index portion 2221 at a first lattice point 2241 and changing its traveling direction by 180 degrees (the thick solid arrow in Fig. 18), and a second ray of light reflected at a second modified refractive index portion 2222 at a second lattice point 2242 and changing its traveling direction by 180 degrees (the thick broken arrow in Fig. 18), have an optical path difference of $2^{-1/2}a=(2^{1/2}a)/2=\lambda/2$. Accordingly, the first and second rays of light will be weakened by interference (in the present case, those rays of light will disappear). Therefore, the intensities of the rays of light which change their traveling directions to other directions than 180 degrees at the first modified refractive index portion 2221 and the second modified refractive index portion 2222 will be relatively higher, and stable lasing can be obtained over a large area within the two-dimensional photonic crystal layer 22. Consequently, the intensity of the pulsed laser light emitted from the two-dimensional photonic crystal laser 20 can be increased.

The previous description was concerned with the case where the first and second rays of light are weakened by interference. There is also the case where the first and second rays of light are strengthened by interference depending on the magnitude or direction of the displacement between the first two-dimensional lattice 2231 and the second two-dimensional lattice 2232. In that case, the interference itself produces the effect of increasing the intensity of the pulsed laser light emitted from the two-dimensional photonic crystal laser 20.

Next, the result of a calculation is described in which the temporal change in the intensity of the emitted pulsed laser light and the emission pattern of the pulsed laser beam were calculated for the two-dimensional photonic crystal laser 20 according to the second embodiment. The calculation assumed that the diameter of the entire first electrode 17 was 250 $\mu$m, the width of each non-conductive section 172 was 6.6 $\mu$m, and seven non-conducive sections 172 were arranged with a period of 44 $\mu$m. In the present case, the diameter of the entire first electrode 17 is set to be larger than the value used in the calculation performed in the first embodiment (150 $\mu$m). This is because, in the second embodiment, stable lasing can be obtained over a large area within the two-dimensional photonic crystal layer 22, as noted earlier. The first modified refractive index portions 2221 and the second modified refractive index portions 2222 have their respective areas modified (with no displacement from the first lattice points 2241 and the second lattice points 2242). The area of the first modified refractive index portions 2221 was modulated within a range of $8\pm3\%$ (5-11%) of the entire area of the two-dimensional photonic crystal layer 22, while that of the second modified refractive index portions 2222 was modulated within a range of $6.5\pm2.5\%$ (4-9%) of the entire area of the two-dimensional photonic crystal layer 22. The modulation phase was set so that inclined pulsed laser beams would be emitted with an inclination angle of $\theta=54$ degrees and azimuth angles of $\varphi=0$ degrees and 180 degrees.

Fig. 19 shows the calculated result of the temporal change in the intensity of the pulsed laser light. The pulsed laser light was obtained with a pulse repetition period of approximately 1 nanosecond. The pulsed laser light had a peak intensity of approximately 6 W, which was higher than the calculated example for the two-dimensional photonic crystal laser 10 according to the first embodiment (approximately 2 W; Figs. 8, 12 and 13). The pulse width of one pulse was 25 picoseconds.

Fig. 20 shows the calculated result of the emission pattern of the pulsed laser beam. In the left panel of Fig. 20, a total of two beam spots can be seen, with one spot in each of the two ranges surrounded by the rectangular frames. One of those spots is shown in an enlarged form in the right panel of Fig. 20. The left panel confirms that two pulsed laser beams are emitted with an inclination angle of $\theta=54$ degrees and azimuth angles of $\varphi=0$ degrees and 180 degrees. The right panel demonstrates that the spread angle of the beam is sufficiently smaller than 1 degree, so that a pulsed laser beam with high intensity can be delivered to a distant area.

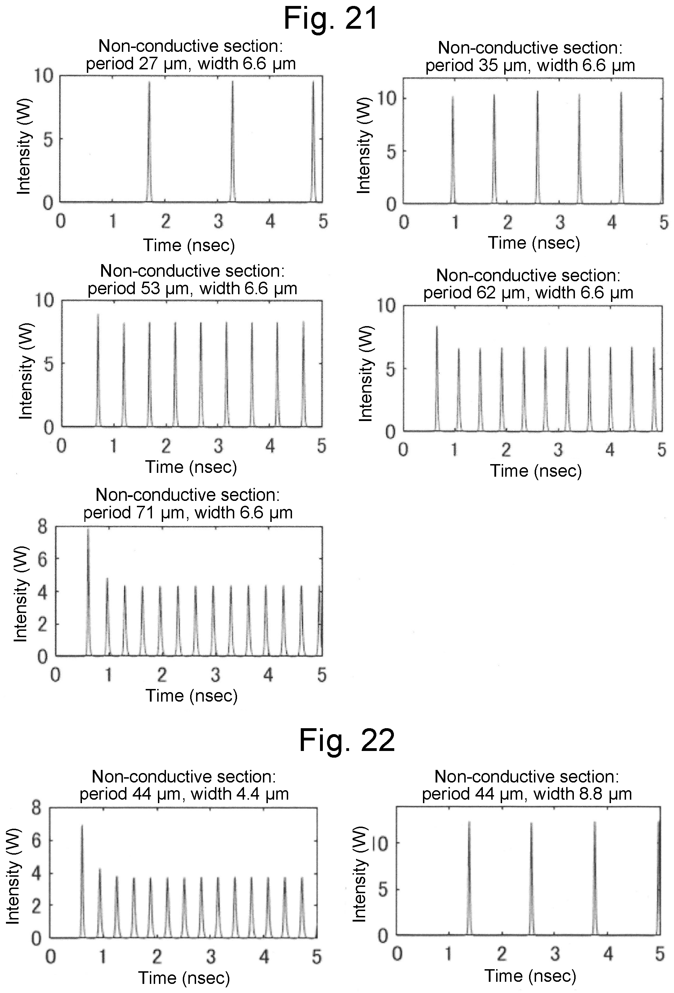

In the two-dimensional photonic crystal laser 20 according to the second embodiment, as in the first embodiment, the non-conductive sections 172 of the first electrode 17 (and the saturable absorber sections 112 of the active layer 11) can take various forms. For example, by a calculation of the temporal change in the intensity of the laser light performed for variations of the two-dimensional photonic crystal laser 20 in which the arrangement period of the non-conductive sections 172 was respectively changed from 44 $\mu$m to 27 $\mu$m, 35 $\mu$m, 53 $\mu$m, 62 $\mu$m and 71 $\mu$m (with no change in the width from 6.6 $\mu$m), it was confirmed that, as shown in Fig. 21, pulsed laser light was generated in all cases. Elongating the arrangement period of the non-conductive sections 172 shortens the pulse repetition period.

A calculation performed for variations in which the width of the non-conductive sections 172 in the two-dimensional photonic crystal laser 20 was respectively changed from 6.6 $\mu$m to 4.4 $\mu$m and 8.8 $\mu$m (with no change in the arrangement period from 44 $\mu$m) also confirmed that, as shown in Fig. 22, pulsed laser light was generated in both cases. Increasing the width of the non-conductive sections 172 elongates the pulse repetition period.

The technique of changing both the arrangement period of the non-conductive sections 172 (and the saturable absorber sections 112; the same applies hereinafter) and the width of the non-conductive sections 172, or changing the extending direction of the non-conductive sections 172, or using non-conductive sections 172 having a non-rectilinear shape, all of which were described in the first embodiment, may also be applied in the two-dimensional photonic crystal laser 20 according to the second embodiment.

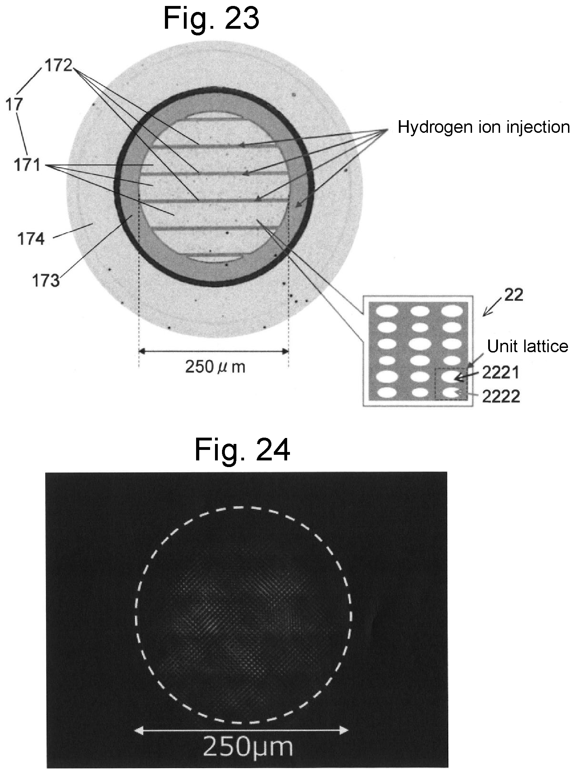

Next, an actually created example of the two-dimensional photonic crystal laser 20 according to the second embodiment is illustrated. In the present example, a first electrode 17 as shown in the microphotograph in Fig. 23 was created. This first electrode 17 is a variation of the example shown in Fig. 5 in which the shape of the peripheral non-conductive section 173 was changed to a circular shape. The first electrode 17 was created by injecting hydrogen ions into portions at which the non-conductive sections 172 and the peripheral non-conductive section 173 should be created in a circular plate material made of gold and having a larger shape than the peripheral non-conductive section 173. In this process, the hydrogen ions reach the active layer 11 and thereby create saturable absorber sections 112 in the active layer 11. The portion 174 outside the peripheral non-conductive section 173 is electrically conductive. However, when this two-dimensional photonic crystal laser 20 is in use, no electric current is injected into this portion 174; the electric current is only injected into the conductive sections 171. The width of the non-conductive sections 172 was 6 $\mu$m. The arrangement period of the non-conductive sections 172 was 45 $\mu$m. The two-dimensional photonic crystal layer 22 was designed by modulating the areas of the first modified refractive index portions 2221 and the second modified refractive index portions 2222 by a technique described in Patent Literature 3 so that a total of 28 laser beam would be emitted, including 14 beams which vary in inclination angle and/or azimuth angle as well as 14 beams which correspond to the 14 aforementioned beams, with each pair of corresponding beams having the same inclination angle and an azimuth-angle difference of 180 degrees. The range of the modulation of the area, as expressed by using period $a$ of the square lattice, was $(0.08\pm0.03)a^2$ for the first modified refractive index portions 2221 and $(0.07\pm0.02)a^2$ for the second modified refractive index portions 2222.

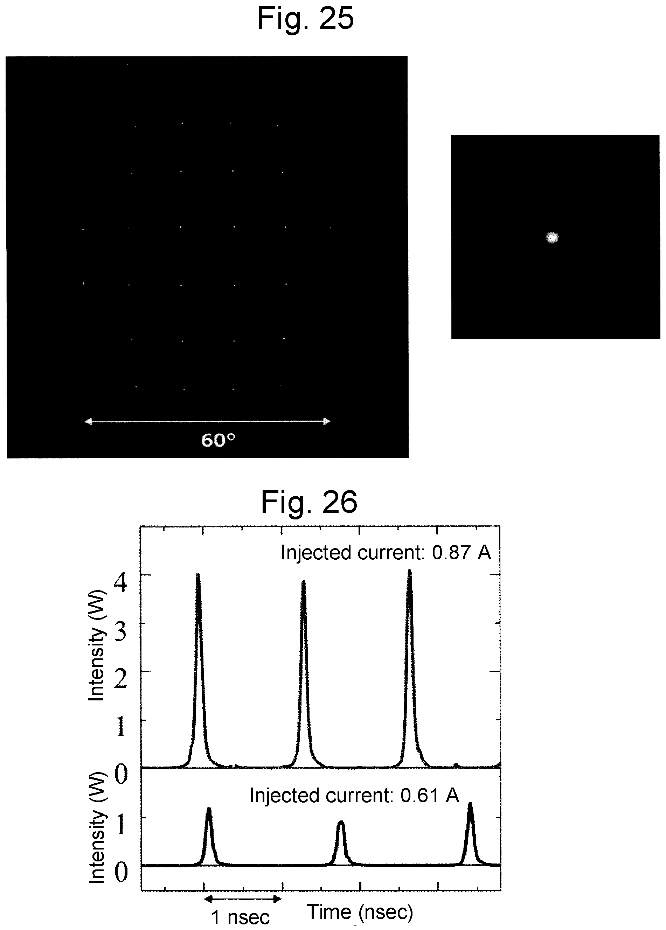

The near-field pattern and the far-field pattern of the obtained pulsed laser beams for the created two-dimensional photonic crystal laser 20 are shown in Figs. 24 and 25, respectively. The far-field pattern demonstrates that more than two beam spots are formed at different positions, and a plurality of pulsed laser beams having different inclination angles $\theta$ and/or azimuth angles $\varphi$ are emitted. An enlarged view of the spot of one of those pulsed laser beams is shown (the right panel of Fig. 25). The spread angle of the beam is approximately 0.46 degrees, which nearly equals the diffraction limit. Therefore, the pulsed laser beam can be delivered to a distant area.

Next, the temporal change in the intensity of the obtained pulsed laser light for the created two-dimensional photonic crystal laser 20 is shown in Fig. 26. Fig. 26 shows two examples in which the electric current passed between the first electrode 17 and the second electrode 18 had magnitudes of 0.61 A and 0.87 A, respectively. The intensity in the present cases is the total of the individual intensity of the obtained pulsed laser beams. In any of those cases, pulsed laser light was obtained with a pulse repetition period of approximately 2 nanoseconds (which was slightly longer in the case of the electric current of 0.61 A).

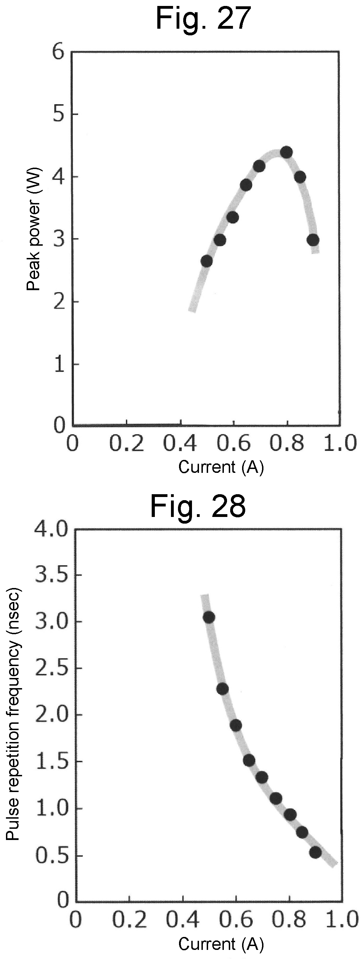

A similar measurement was further performed at other values of the electric current, and the peak value (peak power) of the intensity and the pulse repetition period of the pulsed laser beams obtained in each measurement were determined. The experimental result of the peak power is shown in Fig. 27 and that of the pulse repetition is shown in Fig. 28. The peak power increased with an increase in the electric current injected into the active layer 11 until approximately 0.8 A, and subsequently decreased with a further increase in the electric current. The pulse repetition period monotonically decreased with the increase in the electric current. These results demonstrate that, as the electric current increases, the state of lasing changes from a pulsed form to a state close to a temporally continuous form, causing a decrease in the peak power and the pulse repetition period.

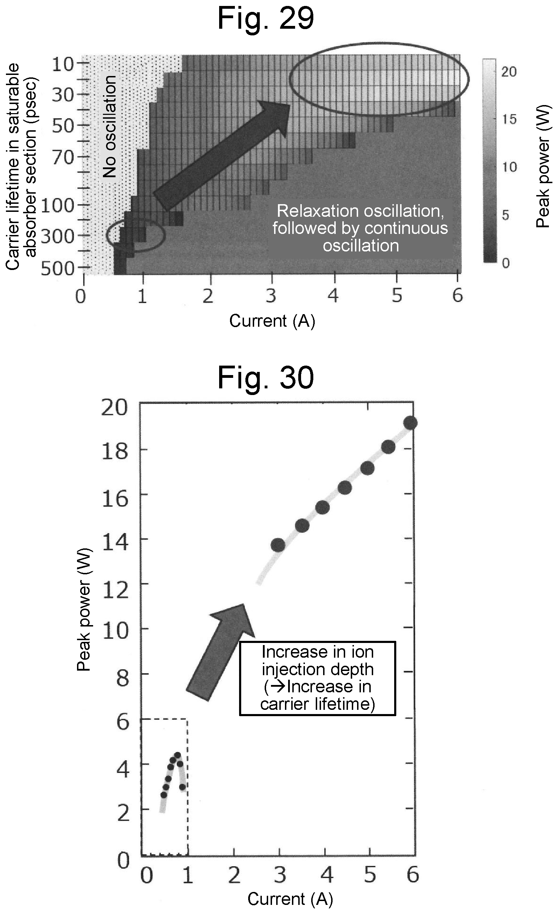

Accordingly, a calculation was performed for determining the relationship of the peak power with the magnitude of the electric current injected into the active layer 11 and the lifetime of carriers in the saturable absorber sections 112. The calculated result is shown in Fig. 29. In this diagram, pulsed laser light was obtained within the region other than those labelled "No lasing" or "Relaxation oscillation, followed by continuous oscillation". Brighter coloring within the region where the pulsed laser light was obtained represents higher peak power. The calculated result demonstrates that increasing the electric current (rightward in Fig. 29) and shortening the carrier lifetime (upward in the same figure) will be effective for increasing the peak power.

In order to elongate the lifetime of carriers, it is effective to increase the thickness of the saturable absorber sections 112 in the active layer 11. Accordingly, in order to increase the thickness of the saturable absorber sections 112, a two-dimensional photonic crystal laser 20 was created with hydrogen ions injected into deeper regions of the active layer 11 by increasing the injection energy of the hydrogen ions to a higher level than in the previously described examples. Fig. 30 shows the result of a measurement of the peak power performed for this two-dimensional photonic crystal laser 20 while varying the magnitude of the electric current injected into the active layer 11. The result demonstrates that the peak power continued increasing and an operation with high levels of peak power ranging from 15 W to 20 W could be achieved even within a range exceeding 0.8 A within which the peak power had turned to decrease with increasing electric current in the previously described example of Fig. 27.

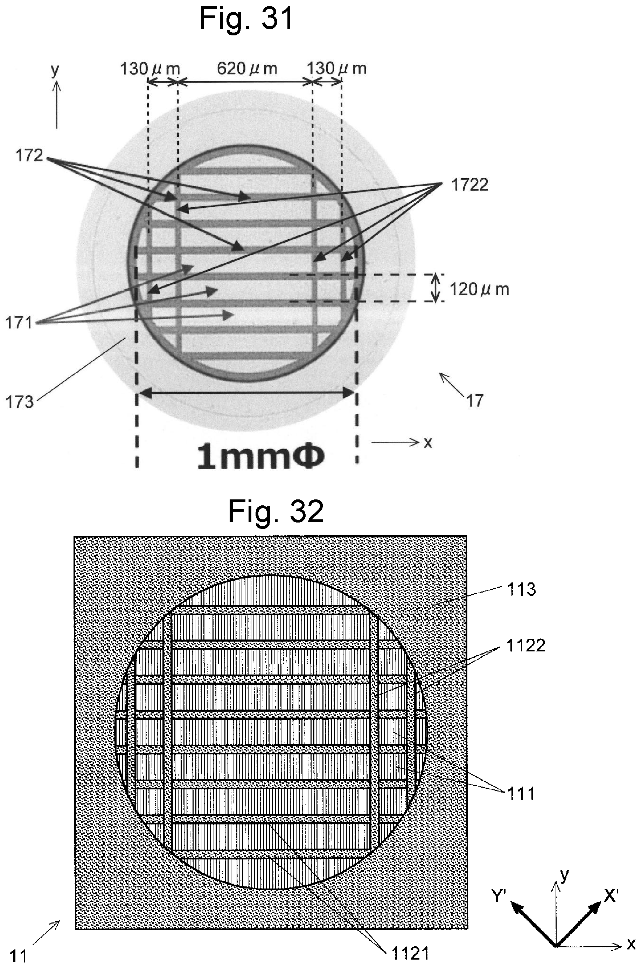

Next, an experiment was performed in which it was attempted to increase the peak power of the pulsed laser light by increasing the electric current injected into the active layer 11 by increasing the area (inner than the peripheral non-conductive section 173) of the first electrode 17 in the two-dimensional photonic crystal laser 20 according to the second embodiment. In this experiment, the diameter of the first electrode 17 was increased (from 250 $\mu$m in the examples of the experiments described so far) to 1 mm. It should be noted that, although increasing the electric current can increase the peak power, it also causes the problem that the lasing of unwanted higher-order modes is more likely to occur. In order to suppress such a lasing of higher-order modes, the ratio $b/a$ of the major axis $a$ and the minor axis b of the ellipses of the first modified refractive index portions 2221 and the second modified refractive index portions 2222 provided in the two-dimensional photonic crystal layer 22 was adjusted, and furthermore, second non-conductive sections 1722 having a linear form extending in the y direction were provided in the first electrode 17 (see the optical microphotograph in Fig. 31) in addition to the non-conductive sections 172 having a linear form extending in the x direction, and the number and positions of those second non-conductive sections 1722 were adjusted. This configuration creates, in the active layer 11, first saturable absorber sections 1121 and second saturable absorber sections 1122 which respectively extend in the x and y directions which are 45 degrees inclined from the X' and Y' directions in which the first modified refractive index portions 2221 and the second modified refractive index portions 2222 are arranged with a period corresponding to the predetermined wavelength $\lambda$ (Fig. 32).

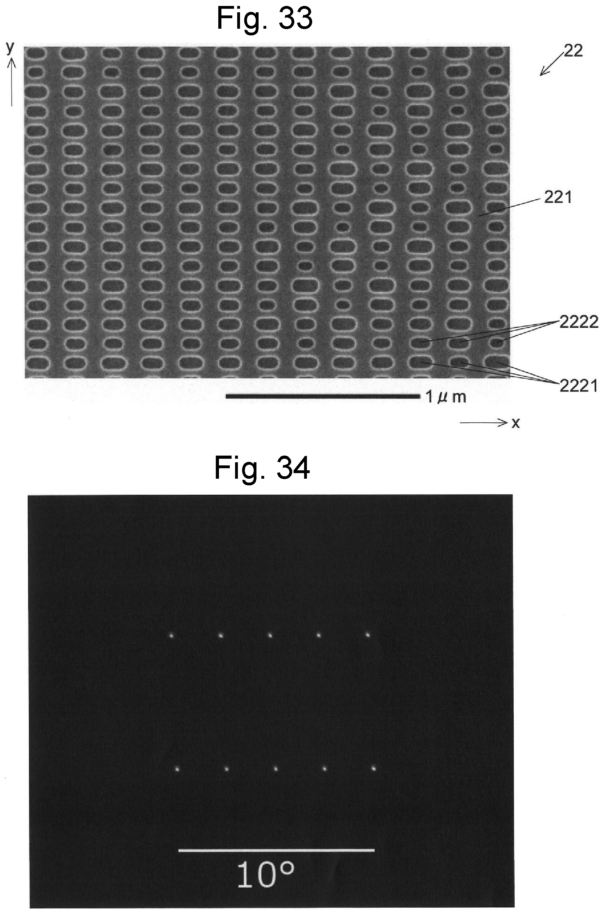

An electron micrograph of the created two-dimensional photonic crystal layer 22 is shown in Fig. 33. In this example, the ratio $b/a$ of the major axis $a$ and the minor axis $b$ of the ellipses of the first modified refractive index portions 2221 and the second modified refractive index portions 2222 in the two-dimensional photonic crystal layer 22 was set to be 0.42. As shown in Fig. 31, two second non-conductive sections 1722 were provided at each of the two end portions in the x direction. The non-conductive sections 172 were arranged at regular intervals over the entire length in the y direction. When an electric current is injected from the first electrode 17 provided with the non-conductive sections 172 and the second non-conductive sections 1722 in this manner, saturable absorber sections which are identical in shape to the non-conductive sections 172 and the second non-conductive sections 1722 will be created in the active layer 11.

The intervals of the second non-conductive sections 1722 were set to be 130 $\mu$m between the two sections neighboring each other in each of the two end portions in the x direction (i.e., between the first and second sections as well as between the third and fourth sections from the left in Fig. 31) and 620 $\mu$m between the two sections neighboring each other across the center of the first electrode 17 (i.e., between the second and third sections from the left in Fig. 31). The width of each second non-conductive section 1722 was 30 $\mu$m. The non-conductive sections 172 were arranged at intervals of 120 $\mu$m. The width of each non-conductive section 172 was 30 $\mu$m.

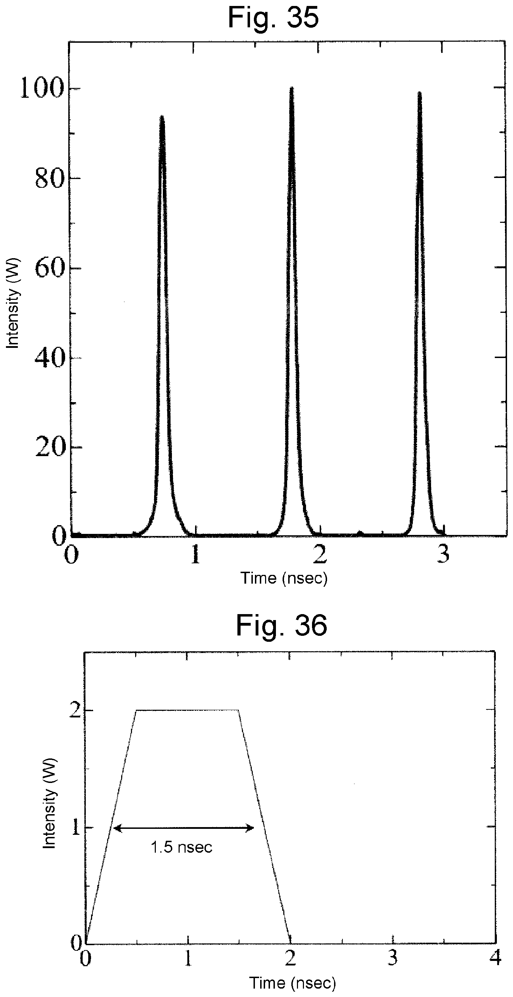

Fig. 34 is a photograph showing a far-field pattern of a laser beam obtained by the two-dimensional photonic crystal laser 20 having the first electrode 17 measuring 1 mm in diameter created in the previously described manner, and Fig. 35 is a graph showing a measured temporal change in the intensity of the laser beam. Ten laser beams can be clearly seen in Fig. 34. Fig. 35 demonstrates that pulsed laser beams having a high maximum peak power of approximately 100 W and a narrow pulse width equal to or less than 50 picoseconds could be obtained.

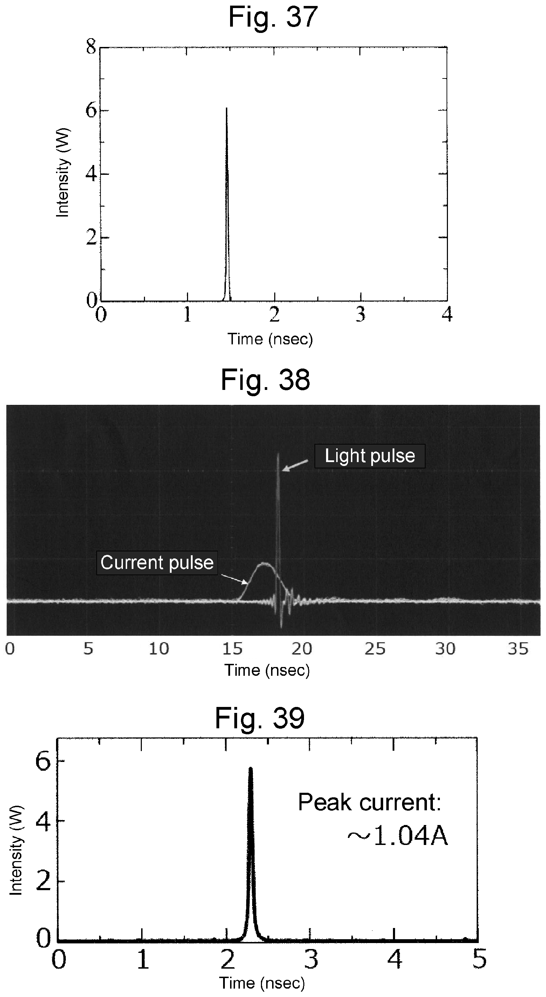

The examples presented so far have assumed the pulsed laser light is repeatedly emitted by continuous injection of an electric current. It is also possible to emit a single pulse of pulsed laser light by injecting an electric current in the form of a short pulse. For example, according to a calculation by the present inventors, a single pulse of pulsed laser light as shown in Fig. 37 can be obtained by injecting a single pulse of electric current as shown in Fig. 36 into a two-dimensional photonic crystal laser 20 configured to emit pulsed laser light having a temporal change in intensity as shown in Fig. 19 in response to continuous injection of an electric current.

Next, a pulsed power supply was connected to an actually created two-dimensional photonic crystal laser 20 according to the second embodiment, and a pulsed electric current was passed between the first electrode 17 and the second electrode 18. The temporal change in the intensity of the outputted pulsed laser beam was measured with a photodiode as well as a streak camera. The peak intensity of the pulsed electric current was set to be approximately 1.04 A. Fig. 38 shows the passed electric current and the intensity of the pulsed laser beam measured with the photodiode, while Fig. 39 shows the intensity of the pulsed laser beam measured with the streak camera. These results confirmed that a single pulse of pulsed laser light can be obtained in the actual two-dimensional photonic crystal laser 20.

(3) Other embodiments

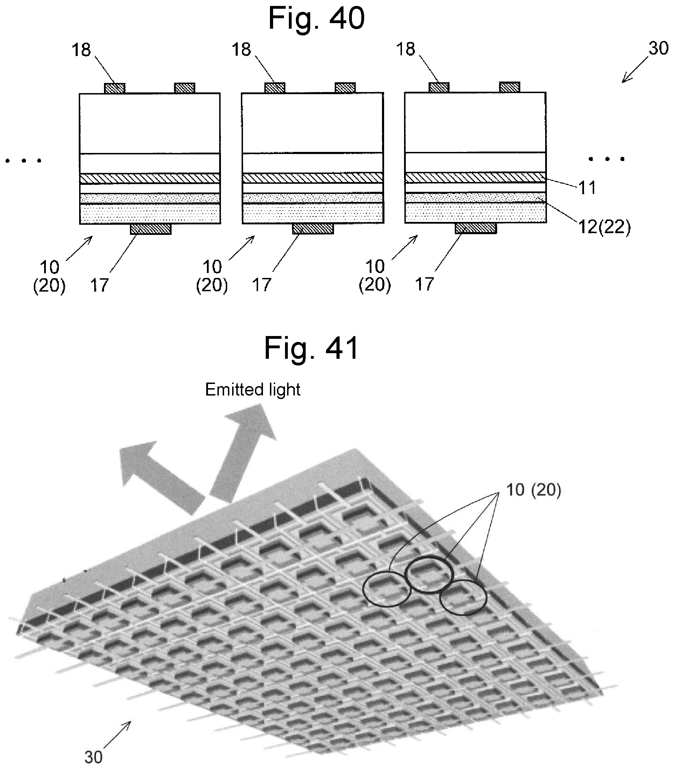

The descriptions so far have been concerned with the configuration of the individual two-dimensional photonic crystal laser 10 or 20 in each embodiment. It is also possible to use a plurality of two-dimensional photonic crystal lasers 10 or 20 in combination. For example, it is possible to construct a single laser device 30 (Figs. 40 and 41) by combining a plurality of two-dimensional photonic crystal lasers 10 which vary in the modulation period of the amount of displacement of the position of the modified refractive index portions 122 from the lattice points 124 or/and that of the area of the modified refractive index portions 122 or a plurality of two-dimensional photonic crystal lasers 20 which similarly vary in modulation period. By this configuration, a plurality of beams of pulsed laser light can be emitted in different directions from the two-dimensional photonic crystal lasers 10 or 20 according to their respective modulation periods. In the example shown in Fig. 40, the two-dimensional photonic crystal lasers 10 or 20 are arranged in a one-dimensional form. It is also possible to arrange a plurality of two-dimensional photonic crystal lasers 10 or 20 in a two-dimensional form as shown in Fig. 41.

A plurality of embodiments for the two-dimensional photonic crystal laser according to the present invention have been described so far. Needless to say, the present invention is not limited to those embodiments and can be embodied in various forms.

(4) Reference example

The descriptions so far have been concerned with a two-dimensional photonic crystal laser configured to emit pulsed laser light in a direction inclined from the normal to the two-dimensional photonic crystal layer by using a two-dimensional photonic crystal layer in which a modulated two-dimensional photonic crystal is created and an electrode which has linear non-conductive sections extending in a predetermined direction. Hereinafter, as a reference example, a two-dimensional photonic crystal laser is described which is configured to emit pulsed laser light in similar directions to the present embodiments by devising the configuration of the two-dimensional photonic crystal layer instead of using the previously described type of electrode.

Patent Literature 4 discloses a two-dimensional photonic crystal laser having a two-dimensional photonic crystal layer in which neither the amount of positional displacement nor the area of the modified refractive index portions is modulated, where the same layer is created so that it has a frequency gradient in which the band-edge frequency (i.e., a frequency corresponding to an energy called a band-edge energy which forms the boundary between a photonic band and a photonic band gap of the two-dimensional photonic crystal) monotonically decreases in one direction parallel to the base body. Non Patent Literature 2 (it should be noted that this literature was published after the priority date (and before the international filing date) of the present application) discloses a two-dimensional photonic crystal laser having a two-dimensional photonic crystal layer in which neither the amount of positional displacement nor the area of the modified refractive index portions is modulated, where the same layer is created so that it has a frequency gradient which the band-edge frequency monotonically decreases with increasing distance from a predetermined reference position (e.g., in the form of a quadratic function with its origin located at the reference position). The example of Patent Literature 4 can also be interpreted as a case in which one end of the one aforementioned direction serves as the reference position and the frequency monotonically decreases with increasing distance from that position. These frequency gradients can be created by increasing the period length of the arrangement of the modified refractive index portions or decreasing the area of the modified refractive index portions with increasing distance from the reference position. The two-dimensional photonic crystal lasers described in those literatures emit pulsed laser light in the direction normal to the two-dimensional photonic crystal layer.

By introducing such a frequency gradient into a modulated two-dimensional photonic crystal, pulsed laser light can be emitted in a direction inclined from the normal to the two-dimensional photonic crystal layer. Specifically, the two following modes can be taken.

The first mode of the two-dimensional photonic crystal laser according to the reference example is a two-dimensional photonic crystal laser including:

an active layer configured to generate light of a predetermined wavelength by being injected with an electric current;
a two-dimensional photonic crystal layer including a plate-shaped base body arranged parallel to the active layer as well as modified refractive index portions arranged in the base body and having a refractive index different from the refractive index of the base body, where the modified refractive index portions are arranged with respective predetermined amounts of displacement from the lattice points of a two-dimensional lattice with a period monotonically increasing with increasing distance from a predetermined reference position, or/and, are arranged at the lattice points and have respective predetermined areas, with the amounts of displacement or/and the areas modulated with a predetermined modulation period; and
a pair of electrodes provided so that the active layer and the two-dimensional photonic crystal layer are sandwiched between the electrodes in a direction perpendicular to the active layer and the two-dimensional photonic crystal layer.

The second mode of the two-dimensional photonic crystal laser according to the reference example is a two-dimensional photonic crystal laser including:

an active layer configured to generate light of a predetermined wavelength by being injected with an electric current;
a two-dimensional photonic crystal layer including a plate-shaped base body arranged parallel to the active layer as well as modified refractive index portions arranged in the base body and having a refractive index different from the refractive index of the base body, where the modified refractive index portions are arranged at lattice points of a two-dimensional lattice and have an area modulated with a predetermined modulation period from a reference area at each lattice point which is an area monotonically decreasing with increasing distance from a predetermined reference position, or the modified refractive index portions are arranged with a positional displacement from the lattice points, with each modified refractive index portion having an amount of displacement modulated with a predetermined modulation period and an area modulated with a predetermined modulation period from the reference area at each lattice point; and
a pair of electrodes provided so that the active layer and the two-dimensional photonic crystal layer are sandwiched between the electrodes in a direction perpendicular to the active layer and the two-dimensional photonic crystal layer.

In the first and second modes of the reference example, the modulation period may be a composite modulation period in which a plurality of different modulation periods are superposed on each other.

As a specific case of the reference example, a calculation was performed for the case where the area of the modified refractive index portions was modulated in the first mode. This calculation used configurations in which modified refractive index portions having modulated areas were arranged at first lattice points of a first lattice formed by monotonically increasing the period length of a square lattice in the y direction as well as at second lattice points of a second lattice having a similar configuration to the first lattice and shifted from the first lattice by a half period length in the y direction. The period length of the first lattice and the second lattice in the y direction was determined so that its difference $\Delta a$ from the period length of the lattice points neighboring in the y direction would satisfy the following equation:

$$\Delta a = a_1 \times (y + L/2)/L + a_2 \times x^2/L^2$$

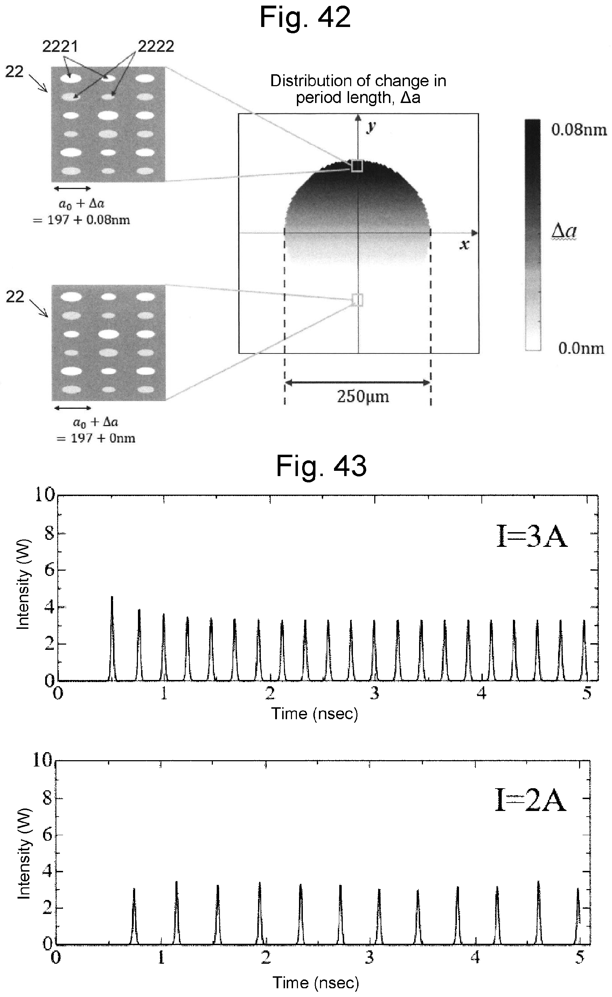

where $a_1$, $a_2$ and $L$ are constants having the dimension of length; in the present calculation example, $a_1$=0.08 nm, $a_2$=0.02 nm and $L$=250 $\mu$m. The area of the first modified refractive index portions was modulated within a range of 8±2% (6-10%) of the entire area of the two-dimensional photonic crystal layer, while the area of the second modified refractive index portions 2222 was modulated within a range of 6.5±1.5% (5-8%) of the entire area of the two-dimensional photonic crystal layer 22. The modulation phase was set so that inclined pulsed laser beams would be emitted with an inclination angle of $\theta$=54 degrees and azimuth angles of $\varphi$=0 degrees and 180 degrees. Fig. 42 is a color gradation map showing the difference in $\Delta a$ at each position in the two-dimensional photonic crystal layer 22 designed in the previously described manner. In the example shown in this figure, $\Delta a$ (and $a$) increases with increasing distance from a reference position which is $x$=0 in the x direction and also increases with increasing distance from a reference position at which y has the smallest value (which is negative and has the largest absolute value) in the y direction.

The temporal change in the intensity of the pulsed laser light obtained by this calculation is shown in the graphs in Fig. 43. The calculation was conducted for two cases in which the injected electric current was set to be 2 A and 3 A, respectively. Both calculations revealed that pulsed laser light with a sufficiently narrow pulse width of less than one nanosecond was repeatedly emitted. The beam was emitted in two directions with an inclination angle of $\theta$=54 degrees and azimuth angles of $\varphi$=0 degrees and 180 degrees.

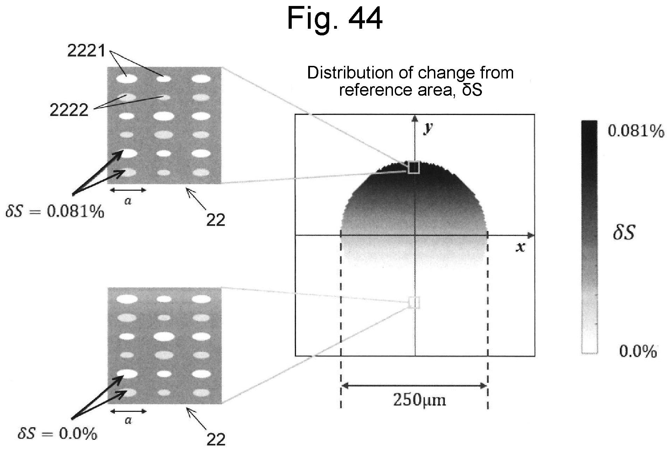

The example shown in Fig. 42 was a case in which $\Delta a$ was varied for each position in the two-dimensional photonic crystal layer 22. It is similarly possible to vary the area (the change $\delta S$ from the reference area) of the modified refractive index portions (first modified refractive index portions 2221 and second modified refractive index portions 2222) for each position within the two-dimensional photonic crystal layer 22 (Fig. 44).

[Modes]

It is evident to a person skilled in the art that the previously described illustrative embodiments are specific examples of the following modes of the present invention.

(Clause 1) A two-dimensional photonic crystal laser according to one mode the present invention includes:

an active layer configured to generate light of a predetermined wavelength which is a laser emission wavelength by being injected with an electric current;
a two-dimensional photonic crystal layer including a plate-shaped base body arranged parallel to the active layer as well as modified refractive index portions arranged in the base body and having a refractive index different from the refractive index of the base body, where the modified refractive index portions are arranged with respective predetermined amounts of displacement from the lattice points of a two-dimensional lattice arrayed in two predetermined directions with a period corresponding to the predetermined wavelength, or/and, are arranged at the lattice points and have respective predetermined areas, where the amounts of displacement or/and the areas are modulated with a predetermined modulation period; and
a pair of electrodes provided so that the active layer and the two-dimensional photonic crystal layer are sandwiched between the electrodes in a direction perpendicular to the active layer and the two-dimensional photonic crystal layer, where the active layer has a saturable absorber section which is a linear section forming a portion of a predetermined range and having no portion parallel to any one of the two predetermined directions, a gain section occupying a portion other than the saturable absorber section within the predetermined range, and a non-gain section formed around the predetermined range, where the saturable absorber section is a section having a lower level of conductivity and a shorter carrier lifetime than the gain section.

(Clause 2) A two-dimensional photonic crystal laser according to Clause 2, which is a two-dimensional photonic crystal laser according to Clause 1, is configured so that a second two-dimensional lattice having second lattice points arrayed with the same period as the lattice points of the aforementioned two-dimensional lattice is further provided at a position displaced from the aforementioned two-dimensional lattice, and second modified refractive index portions having a refractive index different from the refractive index of the base body are arranged at the second lattice points or with respective different amounts of displacement from the second lattice points or/and with respective different areas.

(Clause 3) A two-dimensional photonic crystal laser according to Clause 3, which is a two-dimensional photonic crystal laser according to Clause 1 or 2, is configured so that:

an intermediate layer is provided between one of the pair of electrodes and the active layer;
a low-conductivity section having a lower level of conductivity than other portions of the intermediate layer is created in a portion of the intermediate layer; and
the portion where the low-conductivity section is created is connected to the saturable absorber section of the active layer.

(Clause 4) In a two-dimensional photonic crystal laser according to Clause 4, which is a two-dimensional photonic crystal laser according to one of Clauses 1-3, the amounts of displacement or/and the areas are modulated with a composite modulation period in which a plurality of different modulation periods are superposed on each other.

(Clause 5) In a two-dimensional photonic crystal laser according to Clause 5, which is a two-dimensional photonic crystal laser according to one of Clauses 1-4, the saturable absorber section has a first saturable absorber section linearly extending in a first direction and having no portion parallel to any one of the two predetermined directions as well as a second saturable absorber section linearly extending in a second direction orthogonal to the first direction and having no portion parallel to any one of the two predetermined directions.

(Clause 6) A laser device according to Clause 6 includes a plurality of two-dimensional photonic crystal lasers according to one of Clauses 1-5 which differ from each other in the amounts of displacement or/and the areas.

REFERENCE SIGNS LIST

10, 20 ... Two-Dimensional Photonic Crystal Laser
11 ... Active Layer
111 ... Gain Section
112 ... Saturable Absorber Section
1121 ... First Saturable Absorber Section
1122 ... Second Saturable Absorber Section
113 ... Non-Gain Section
12, 22 ... Two-Dimensional Photonic Crystal Layer
121, 221 ... Base Body
122 ... Modified Refractive Index Portion
123 ... Two-Dimensional Lattice
124 ... Lattice Point
125 ... Center (Centroid) of Planer Shape of Modified Refractive Index Portion
126 ... Vector Representing Amount of Displacement
13 ... Spacer Layer
141 ... First Cladding Layer
142 ... Second Cladding Layer
16 ... Substrate
17 ... First Electrode
171, 971 ... Conductive Section
172, 972 ... Non-Conductive Section
1722 ... Second Non-Conductive Section
173 ... Peripheral Non-Conductive Section
174 ... Portion Outside the Circumference of Peripheral Non-Conductive Section
18 ... Second Electrode
181 ... Frame Portion
182 ... Window Portion
19 ... Intermediate Layer
191 ... High-Conductivity Section
192 ... Low-Conductivity Section

2221 ... First Modified Refractive Index Portion
2222 ... Second Modified Refractive Index Portion
2231 ... First Two-Dimensional Lattice
2232 ... Second Two-Dimensional Lattice
2241 ... First Lattice Point
2242 ... Second Lattice Point
30 ... Laser Device
97 ... Electrode

**Claims**

1. A two-dimensional photonic crystal laser, comprising:

   an active layer configured to generate light of a predetermined wavelength which is a laser emission wavelength by being injected with an electric current;
   a two-dimensional photonic crystal layer including a plate-shaped base body arranged parallel to the active layer as well as modified refractive index portions arranged in the base body and having a refractive index different from a refractive index of the base body, where the modified refractive index portions are arranged with respective predetermined amounts of displacement from lattice points of a two-dimensional lattice arrayed in two predetermined directions with a period corresponding to the predetermined wavelength, or/and, are arranged at the lattice points and have respective predetermined areas, where the amounts of displacement or/and the areas are modulated with a predetermined modulation period; and
   a pair of electrodes provided so that the active layer and the two-dimensional photonic crystal layer are sandwiched between the electrodes in a direction perpendicular to the active layer and the two-dimensional photonic crystal layer,
   where the active layer has a saturable absorber section which is a linear section forming a portion of a predetermined range and having no portion parallel to any one of the two predetermined directions, a gain section occupying a portion other than the saturable absorber section within the predetermined range, and a non-gain section formed around the predetermined range, where the saturable absorber section is a section having a lower level of conductivity and a shorter carrier lifetime than the gain section.

2. The two-dimensional photonic crystal laser according to claim 1, wherein a second two-dimensional lattice having second lattice points arrayed with the same period as the lattice points of the aforementioned two-dimensional lattice is further provided at a position displaced from the aforementioned two-dimensional lattice, and second modified refractive index portions having a refractive index different from the refractive index of the base body are arranged at the second lattice points or with respective different amounts of displacement from the second lattice points or/and with respective different areas.

3. A laser device comprising the two-dimensional photonic crystal laser according to claim 1, wherein:

   an intermediate layer is provided between one of the pair of electrodes and the active layer;
   a low-conductivity section having a lower level of conductivity than other portions of the intermediate layer is created in a portion of the intermediate layer; and
   the portion where the low-conductivity section is created is connected to the saturable absorber section of the active layer.

4. The two-dimensional photonic crystal laser according to claim 1 or 2, wherein the amounts of displacement or/and the areas are modulated with a composite modulation period in which a plurality of different modulation periods are superposed on each other.

5. The two-dimensional photonic crystal laser according to claim 1 or 2, wherein the saturable absorber section has a first saturable absorber section linearly extending in a first direction and having no portion parallel to any one of the two predetermined directions as well as a second saturable absorber section linearly extending in a second direction orthogonal to the first direction and having no portion parallel to any one of the two predetermined directions.

6. A laser device comprising a plurality of two-dimensional photonic crystal lasers according to claim 1 or 2 which differ from each other in the amounts of displacement or/and the areas.

# Fig. 1

# Fig. 2

# Fig. 3

$$\lambda = \sqrt{2}a$$

# Fig. 4

# Fig. 5

# Fig. 6

EP 4 776 448 A1

# Fig. 7

<Comparative Example>

# Fig. 8

23

# Fig. 9

<Comparative Example>

# Fig. 10

Near-field pattern    Far-field pattern

250 μm    2°

# Fig. 11

<Comparative Example>
Near-field pattern    Far-field pattern

250 μm    2°

## Fig. 12

Non-conductive section:
period 17 μm, width 2.75 μm

Non-conductive section:
period 28 μm, width 2.75 μm

## Fig. 13

Non-conductive section:
period 22 μm, width 4.1 μm

Non-conductive section:
period 22 μm, width 5.5 μm

# Fig. 14

Near-field pattern (α=40°)

Far-field pattern (α=40°)

250 μm

2°

Near-field pattern (α=30°)

Far-field pattern (α=30°)

# Fig. 15

173

172

171

17

Fig. 16

# Fig. 17

# Fig. 18

$$\text{Optical path difference} = \frac{1}{2\sqrt{2}}a \times 2$$

$$= \frac{1}{\sqrt{2}}a \quad (2^{-0.5}\,a)$$

$$= \frac{1}{2}\lambda$$

# Fig. 19

# Fig. 20

# Fig. 21

**Non-conductive section: period 27 μm, width 6.6 μm**

**Non-conductive section: period 35 μm, width 6.6 μm**

**Non-conductive section: period 53 μm, width 6.6 μm**

**Non-conductive section: period 62 μm, width 6.6 μm**

**Non-conductive section: period 71 μm, width 6.6 μm**

# Fig. 22

**Non-conductive section: period 44 μm, width 4.4 μm**

**Non-conductive section: period 44 μm, width 8.8 μm**

## Fig. 23

## Fig. 24

## Fig. 25

60°

## Fig. 26

Injected current: 0.87 A

Injected current: 0.61 A

1 nsec    Time (nsec)

# Fig. 27

# Fig. 28

# Fig. 29

# Fig. 30

# Fig. 31

# Fig. 32

# Fig. 33

# Fig. 34

## Fig. 35

## Fig. 36

## Fig. 37

## Fig. 38

## Fig. 39

# Fig. 40

18       18       18       30

11

12(22)

10
(20)   17

10
(20)   17

10
(20)   17

# Fig. 41

Emitted light

10 (20)

30

# Fig. 42

2221   2222

22

22

$a_0 + \Delta a$
$= 197 + 0.08nm$

$a_0 + \Delta a$
$= 197 + 0nm$

Distribution of change in
period length, Δa

$y$

$x$

250μm

0.08nm

$\Delta a$

0.0nm

# Fig. 43

I=3A

Intensity (W)

Time (nsec)

I=2A

Intensity (W)

Time (nsec)

# Fig. 44

2221

2222

$\delta S = 0.081\%$

$a$

22

$\delta S = 0.0\%$

$a$

22

Distribution of change from reference area, δS

$y$

$x$

$250\mu m$

0.081%

$\delta S$

0.0%

# EP 4 776 448 A1

## INTERNATIONAL SEARCH REPORT

| | |
|---|---|
| | International application No. |
| | **PCT/JP2024/031509** |

### A. CLASSIFICATION OF SUBJECT MATTER

*H01S 5/18*(2021.01)i; *H01S 5/11*(2021.01)i
FI: H01S5/18; H01S5/11

According to International Patent Classification (IPC) or to both national classification and IPC

### B. FIELDS SEARCHED

Minimum documentation searched (classification system followed by classification symbols)

H01S5/18; H01S5/11

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/181723 A1 (KYOTO UNIVERSITY) 01 September 2022 (2022-09-01) | 1-6 |
| A | WO 2014/136607 A1 (JAPAN SCIENCE AND TECHNOLOGY AGENCY) 12 September 2014 (2014-09-12) | 1-6 |
| A | JP 2023-28421 A (CANON KABUSHIKI KAISHA) 03 March 2023 (2023-03-03) | 1-6 |

☐ Further documents are listed in the continuation of Box C.   ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **11 October 2024** | **22 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/031509**

| Patent document cited in search report | | | Publication date (day/month/year) | Patent family member(s) | | | Publication date (day/month/year) |
|---|---|---|---|---|---|---|---|
| WO | 2022/181723 | A1 | 01 September 2022 | US | 2024/0128717 | A1 | |
| | | | | EP | 4300731 | A1 | |
| | | | | CN | 116897478 | A | |
| WO | 2014/136607 | A1 | 12 September 2014 | US | 2016/0248224 | A1 | |
| | | | | EP | 2966737 | A1 | |
| | | | | CN | 105191029 | A | |
| JP | 2023-28421 | A | 03 March 2023 | US | 2023/0059270 | A1 | |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014136607 A
- US 20160248224 A
- WO 2022181723 A
- WO 2021039316 A

**Non-patent literature cited in the description**

- **RYOHEI MORITA**. Photonic-crystal lasers with two-dimensionally arranged gain and loss sections for high-peak-power short-pulse operation. *Nature Photonics, Nature Research (Great Britain)*, 04 March 2021, vol. 15, 311-318
- **RYOHEI MORITA**. 200-W short-pulse operation of photonic-crystal lasers based on simultaneous absorptive and radiative Q-switching. *Optics Express, Optica*, 06 September 2023